(19) Europäisches Patentamt
European Patent Office
Office européen des brevets

(11) **EP 2 889 397 B1**

(12) **EUROPEAN PATENT SPECIFICATION**

(45) Date of publication and mention
of the grant of the patent:
**03.04.2019 Bulletin 2019/14**

(51) Int Cl.:
*C30B 19/10* (2006.01)   *C30B 29/36* (2006.01)
*C30B 17/00* (2006.01)   *C30B 9/06* (2006.01)
*C30B 19/04* (2006.01)   *C30B 19/06* (2006.01)
*C30B 29/06* (2006.01)   *C30B 29/20* (2006.01)

(21) Application number: **13832154.2**

(22) Date of filing: **26.08.2013**

(86) International application number:
**PCT/JP2013/005017**

(87) International publication number:
**WO 2014/034081 (06.03.2014 Gazette 2014/10)**

(54) **SIC SINGLE CRYSTAL PRODUCING METHOD**

VERFAHREN ZUR HERSTELLUNG VON SIC-EINKRISTALLEN

PROCÉDÉ DE PRODUCTION POUR DES MONOCRISTAUX SIC

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.08.2012 JP 2012185971**
**26.08.2012 JP 2012185973**
**26.08.2012 JP 2012185974**
**26.08.2012 JP 2012185975**

(43) Date of publication of application:
**01.07.2015 Bulletin 2015/27**

(73) Proprietor: **National University Corporation Nagoya University**
**Aichi 464-8601 (JP)**

(72) Inventors:
• **UJIHARA, Toru**
**Nagoya-shi**
**Aichi 464-8601 (JP)**
• **HARADA, Shunta**
**Nagoya-shi**
**Aichi 464-8601 (JP)**
• **SEKI, Kazuaki**
**Nagoya-shi**
**Aichi 464-8601 (JP)**
• **ZHU, Can**
**Nagoya-shi**
**Aichi 464-8601 (JP)**
• **NAGAOKA, Mitsuya**
**Iruma-shi**
**Saitama 358-0032 (JP)**

(74) Representative: **TBK**
**Bavariaring 4-6**
**80336 München (DE)**

(56) References cited:
EP-A1- 1 806 437    WO-A1-2010/103387
WO-A1-2012/173251    WO-A1-2013/081164
JP-A- H11 171 689    JP-A- 2003 277 193
JP-A- 2003 321 298    JP-A- 2005 179 080
JP-A- 2008 100 854    JP-A- 2008 308 347
JP-A- 2011 051 857    JP-A- 2013 173 645
US-A1- 2012 073 495

**Description**

[Technical Field]

The present invention relates to a SiC single crystal producing method.

[Background Art]

As a method of producing a single crystal, a method of growing a crystal from a seed crystal in a vapor phase (so-called a vapor phase growth method) and a method of growing a crystal from a seed crystal in a liquid phase (so-called a liquid phase growth method) are known. The liquid phase growth method enables crystal growth in a state close to thermal equilibrium compared to the vapor phase growth method, and thus it is thought that a high quality single crystal is obtained.

As an apparatus for the liquid phase growth method, various apparatuses are known. In recent years, it is thought that, in order to achieve an quality enhancement of a single crystal, it is preferable to suppress convection or whirlpool of a raw material solution along a crystal growth surface of the single crystal (for example, refer to PTL 1).

However, since the raw material solution is a liquid, completely eliminating convection or whirlpool (forced flow) itself is impossible. Therefore, an effect of the flow of the raw material solution on the crystal growth of the single crystal cannot be completely excluded. In addition, in PTL 1, convection is suppressed by disposing a convection control member in a liquid tub (specifically, a crucible) which accommodates a raw material solution. However, it is thought that disposing the convection control member in the liquid tub which is a limited space causes a new problem. That is, as the convection control member is disposed in the liquid tub, the space in the liquid tub is reduced, and it becomes difficult to produce a large single crystal. Furthermore, the liquid tub itself needs to be increased in size, which results in a problem of an increase in the size of the apparatus. Even when such a crystal producing apparatus is used, it is still difficult to produce a single crystal having excellent quality, and a further improvement of the crystal producing apparatus is desired.

PTL 2 discloses a SiC single crystal producing method which has the features defined in the preamble of claims 1 and 2. The crystal producing apparatus used in this method comprises a pulling axis which is rotatable about an axis center thereof and has a lower half part deviated from the axis center and a crystal supporting part at the lower end of the lower half part of the pulling axis, which holds a seed crystal at an eccentric position which does not intersect the axis center. The pulling axis is rotated such that the seed crystal orbits on a horizontal circle whose center is the axis center.

PTL 3 discloses a SiC single crystal producing method of creating a forced flow in a SiC solution, wherein only the crucible accommodating the SiC solution is rotated or both the crucible and the seed crystal are rotated.

PTL 4 discloses a crystal producing apparatus having an XY table system equipped with a center aligning function for aligning precisely a crystal axis center and a crucible axis center.

PTL 5 discloses a SiC single crystal comprising: a first layer which is close to a seed crystal made of 4H-SiC and includes a threading screw dislocation; a second layer which is formed continuously from the first layer and includes a stacking fault converted from the threading screw dislocation; and a third layer which is formed continuously from the second layer and includes a smaller number of threading screw dislocations than that of the first layer.

PTL 6 discloses a manufacturing apparatus for manufacturing an oxide single crystal film. The manufacturing apparatus comprises a crucible that accommodates a melt obtained by melting a raw material of the oxide single crystal film, and a holder for holding, one above the other, two disk-shaped substrates on which the oxide single crystal film is to be formed. The holder is configured to hold the substrates in the crucible on the outside in a radial direction from a z-axis of the crucible that extends in a depth direction of the crucible and that is positioned at a center of the radial cross-section and to revolve the substrates around the z-axis and rotate on its own axis so as to stir the melt.

[Citation List]

[Patent Literature]

   [PTL 1] JP 2011 126738 A
   [PTL 2] JP 2008 100854 A
   [PTL 3] EP 1 806 437 A1
   [PTL 4] JP 2008 308347 A
   [PTL 5] US 2012/0073495 A1
   [PTL 6] JP H11 171689 A

[Summary of Invention]

[Technical Problem]

The present invention has been done taking the foregoing circumstances into consideration, and an object thereof is to provide a method capable of producing a SiC single crystal having excellent quality.

[Solution to Problem]

The inventors of the present invention intensively studied, and as a result, have found that convection or forced flow in a liquid phase (that is, a raw material solution) is not suppressed, but instead, crystal growth is allowed to proceed while a crystal growth surface itself of a seed crystal (or a single crystal formed on the seed crystal) is exposed to the convection or forced flow of the raw material solution such that the internal shape or surface shape of the crystal can be arranged. For example, the inventors of the present invention have found that, during crystal growth of a single crystal on a seed crystal, when the raw material solution is allowed to flow in the same direction as a step developing direction, step bunching occurs on the crystal growth surface, and thus a single crystal can be grown with forming steps having great step heights (called macrosteps). In addition, it has been found that as the macrosteps are developed on defects such as threading screw dislocations, which extend in a crystal growth direction (a direction perpendicular to the crystal growth surface), the defects that extend in the crystal growth direction can be converted into defects of a basal plane.

In addition, the inventors of the present invention have found that, during crystal growth of a single crystal on a seed crystal, when the raw material solution is allowed to flow in a direction opposite to the step developing direction, step bunchings on the crystal growth surface are reduced and thus the step heights can be reduced, thereby smoothing the crystal growth surface.

As described above, by actively allowing the flow of the raw material solution to occur in the vicinity of the crystal growth surface of the seed crystal, it is possible to obtain a single crystal having excellent quality.

That is, a SiC single crystal producing method of the present invention to solve the problem described above is a SiC single crystal producing method including the features defined in claim 1 or 2.

According to the crystal producing apparatus used in the SiC single crystal producing method of the present invention, it is possible to produce a single crystal having excellent quality as described above. In addition, according to the crystal producing apparatus, the seed crystal held by the crystal holding element can be moved in a direction perpendicular to the depth direction of the liquid tub (z-axis direction) and thus the flowing direction of the raw material solution with respect to the crystal growth surface of the seed crystal can be adjusted to various directions. Furthermore, according to the crystal producing apparatus, since the flowing direction of the raw material solution with respect to the crystal growth surface of the seed crystal can be set to two directions that are 180° different from each other, for example, it is possible to set the flowing direction of the raw material solution to the same direction as the step developing direction of the single crystal and thereafter to a direction opposite to the step developing direction. When the single crystal is produced as described above, it is possible to obtain a single crystal having a small number of defects and a smooth surface. That is, the crystal producing apparatus can be particularly appropriately used as an apparatus for producing a single crystal having a small number of defects and a smooth surface.

The crystal producing apparatus used in the SiC single crystal producing method of the present invention has a simple structure and causes the raw material solution to smoothly flow in the liquid tub and also causes the seed crystal to be exposed to the flowing raw material solution.

The crystal producing apparatus used in the present invention is preferably provided with any of the following [1] and [2].

[1] The raw material solution is allowed to flow by movement of the crystal holding element, and the solution flowing element includes the crystal holding element.
[2] The crystal holding element includes a guide element which guides a movement direction of the dipping shaft portion, and the guide element includes a z-direction guide portion which guides the dipping shaft portion to the z-axis direction, an x-direction guide portion which guides the dipping shaft portion to an x-axis direction which is one direction on the xy plane, and a y-direction guide portion which guides the dipping shaft portion to a y-axis direction which is one direction on the xy plane and intersects the x-axis direction.

According to the crystal growth apparatus provided with [1], the raw material solution can be efficiently caused to flow with a simple configuration.

The crystal producing apparatus provided with [2] can three-dimensionally (sterically) move the seed crystal in the x-axis direction, the y-axis direction, and the z-axis direction using the crystal holding element. Therefore, the seed crystal can be disposed at an expected position and thus the flowing direction of the raw material solution with respect to the crystal growth surface of the seed crystal can be set to an expected direction.

Please note that the single crystal obtained by the SiC single crystal producing method of the present invention may be used as a substrate of various types of devices or may also be used as a seed crystal.

As set forth in claim 1, one of SiC single crystal producing methods of the present invention to solve the problem described above uses the crystal producing apparatus described above and is a method including:

a crystal growth process of growing a SiC single crystal by developing steps made of SiC on a crystal growth surface of a SiC seed crystal by a liquid phase growth method in a raw material solution containing silicon (Si) and carbon (C), wherein the crystal growth process includes a smoothening process of removing at least a portion of step bunchings on the crystal growth surface by causing the raw material solution to flow along a direction opposite to a developing direction of the steps by adding an external force to the raw material solution using the solution flowing element.

Since the producing method of the present invention includes the smoothening process, the surface of the SiC single crystal in which step bunchings are generated and relatively large uneven portions are formed can be substantially smoothened. Therefore, according to the SiC single crystal producing method of the present invention, it is possible to obtain a SiC single crystal in which the surface is substantially smoothened without polishing and cutting. In addition, the SiC single crystal producing method of the present invention can be easily performed by using the crystal producing apparatus of the present invention described above.

Furthermore, as set forth in claim 2, the other of the SiC single crystal producing methods of the present invention to solve the problem uses the crystal producing apparatus described above and is a method including:

a crystal growth process of growing a SiC single crystal by developing steps made of SiC on a crystal growth surface of a SiC seed crystal by a liquid phase growth method in a raw material solution containing silicon (Si) and carbon (C), wherein the crystal growth process includes a bunching process of generating step bunchings on the crystal growth surface by causing the raw material solution to flow along a developing direction of the steps by adding an external force to the raw material solution using the solution flowing element.

The inventors of the present invention intensively studied, and as a result, have found that a single crystal can be grown while forming steps having great heights by causing step bunching through crystal growth of a seed crystal under specific conditions using a liquid phase growth method. According to the SiC single crystal producing method of the present invention, since step bunching occurs in the bunching process, it is possible to grow a single crystal while forming steps having great heights. In addition, by performing the bunching process before the smoothening process, the crystal growth can be performed while developing the steps having great heights and thereafter the crystal growth surface can be substantially smoothened. In this case, the flowing direction of the raw material solution with respect to the crystal growth surface of the seed crystal may be switched between two directions that are 180° different from each other. For example, when the flowing direction of the raw material solution is caused to be the same direction as the step developing direction of the SiC single crystal and is thereafter caused to be a direction opposite to the step developing direction, it is possible to obtain a SiC single crystal having a small number of defects and a smooth surface.

[Advantageous Effects of Invention]

According to the SiC single crystal producing method of the present invention, it is possible to produce a single crystal having excellent quality.

[Brief Description of Drawings]

Fig. 1 is an explanatory drawing schematically illustrating a crystal producing apparatus used in a first embodiment.
Fig. 2 is an explanatory drawing schematically illustrating the positions of a crystal holding element, a crucible, and a seed crystal in the crystal producing apparatus.
Fig. 3 is an explanatory drawing schematically illustrating a form in which an off angle is formed at the (0001) plane of a SiC single crystal.
Fig. 4 is an explanatory drawing schematically illustrating the positions of the crucible, the flowing direction of a SiC solution, and a position of the seed crystal in the crystal producing apparatus.
Fig. 5 is an atomic force micrograph of a SiC single crystal 1a and a graph of step heights at positions between A-B of the atomic force micrograph.
Fig. 6 is an atomic force micrograph of a SiC single crystal 1b and a graph of step heights at positions between C-D of the atomic force micrograph.

Fig. 7 is an explanatory drawing schematically illustrating the relationship between a step developing direction, a terrace surface, and a step height in a single crystal during crystal growth.

Fig. 8 is a graph illustrating a change in step height with time in the SiC single crystals 1a and 1b during crystal growth.

Fig. 9 is an explanatory drawing schematically illustrating a crystal producing apparatus used in a second embodiment.

Fig. 10 is an X-ray topograph of a seed crystal and a SiC single crystal at an initial stage of crystal growth according to a method of Test 1, which are taken at the same point.

Fig. 11 is an X-ray topograph of the seed crystal.

Fig. 12 is an X-ray topograph of a SiC single crystal at an initial stage of crystal growth according to a method of Test 3.

Fig. 13 is a Nomarski differential interference contrast micrograph of the SiC single crystal of Test 3.

Fig. 14 is a graph illustrating the relationship between an off angle, a step height, and a conversion ratio (%) of threading screw dislocations.

Fig. 15 is a laser micrograph of the SiC single crystal of Test 1.

Fig. 16 is a laser micrograph of a SiC single crystal of Test 2.

Fig. 17 is a laser micrograph of the SiC single crystal of Test 3.

Fig. 18 is an explanatory drawing schematically illustrating the steps of a SiC single crystal.

Fig. 19 is a graph illustrating the relationship between a step height and an off angle in each of the SiC single crystals of Tests 1 to 3.

Fig. 20 is a graph illustrating the relationship between a terrace width and an off angle in each of the SiC single crystals of Tests 1 to 3.

Fig. 21 is an explanatory drawing schematically illustrating a form in which threading screw dislocations are converted.

Fig. 22 is an explanatory drawing schematically illustrating a form in which threading screw dislocations are converted.

Fig. 23 is an explanatory drawing schematically illustrating a form in which threading screw dislocations are converted.

Fig. 24 is an explanatory drawing schematically illustrating a form in which threading screw dislocations are converted.

Fig. 25 is an explanatory drawing schematically illustrating the relationship between the height (h) of a macrostep, the step developing speed ($V_{step}$) of the macrostep, a terrace width (w), and the growth speed ($V_{spiral}$) of a screw dislocation.

Fig. 26 is an explanatory drawing schematically illustrating a macrostep forming process.

Fig. 27 is an explanatory drawing schematically illustrating a macrostep forming process.

Fig. 28 is a micrograph of a SiC single crystal of Test 4 taken by using a Nomarski differential interference contrast microscope.

Fig. 29 is a micrograph of a SiC single crystal of Test 5 taken by using the Nomarski differential interference contrast microscope.

Fig. 30 is an X-ray topograph of the SiC single crystal of Test 5 taken at the same point as that of Fig. 29.

Fig. 31 is an explanatory drawing schematically illustrating a form in which a SiC single crystal is grown on a seed crystal provided with an off angle by a liquid phase growth method.

Fig. 32 is an explanatory drawing schematically illustrating a SiC seed crystal used in a SiC single crystal producing method of Test 6.

Fig. 33 is an explanatory drawing schematically illustrating a form in which a SiC single crystal is grown on the SiC seed crystal in the SiC single crystal producing method of Test 6.

Fig. 34 is a micrograph illustrating a form in which the crystal surface of the SiC single crystal of Test 6 is subjected to molten KOH etching.

Fig. 35 is a micrograph illustrating a form in which the crystal surface of the SiC single crystal of Test 6 is subjected to molten KOH etching.

Fig. 36 is an explanatory drawing schematically illustrating the Burgers vectors of threading edge dislocations formed on a SiC seed crystal made of a hexagonal crystal and (1) to (3) directions formed on the basis of the Burgers vectors.

Figs. 37(a) to 37(f) are X-ray topographs of the surface of the SiC seed crystal.

Fig. 38 is an X-ray topograph of a seed crystal, and a SiC single crystal at an initial stage of crystal growth according to a method of Test 7, which are taken at the same point.

Fig. 39 is a graph illustrating the relationship between a step developing direction, the Burgers vectors of threading edge dislocations and a conversion ratio of the threading edge dislocations in the SiC single crystal of Test 7.

Fig. 40 is a laser micrograph of a SiC single crystal of Test 8.

Fig. 41 is a laser micrograph of a SiC single crystal of Test 9.

Fig. 42 is a laser micrograph of a SiC single crystal of Test 10.

Fig. 43 is a cross-sectional transmission electron micrograph of the SiC single crystal of Test 8.

Fig. 44 is a cross-sectional transmission electron micrograph of the SiC single crystal of Test 9.

Fig. 45 is a cross-sectional transmission electron micrograph of the SiC single crystal of Test 10.

Fig. 46 is an X-ray topograph of the SiC single crystal of Test 8.

Fig. 47 is an X-ray topograph of the SiC single crystal of Test 9.

Fig. 48 is an X-ray topograph of the SiC single crystal of Test 10.

Fig. 49 is a micrograph of the SiC single crystal 1a produced in the first embodiment, taken by the Nomarski differential interference contrast microscope.

Fig. 50 is a micrograph of the SiC single crystal 1b produced in the first embodiment, taken by the Nomarski differential interference contrast microscope.

Fig. 51 is a micrograph of the SiC single crystal 1a produced in the first embodiment, taken by an atomic force microscope.

Fig. 52 is a micrograph of the SiC single crystal 1b produced in the first embodiment, taken by the atomic force microscope.

Fig. 53 is an explanatory drawing schematically illustrating a profile in a height direction between A-B in Fig. 51.

Fig. 54 is an explanatory drawing schematically illustrating a profile in a height direction between A-B in Fig. 52.

Fig. 55 is a graph illustrating the relationship between the thickness ($\mu$m) of the SiC single crystal layer grown on the SiC seed crystal and a growth time (min), regarding the SiC single crystals 1a and 1b produced in the first embodiment.

Fig. 56 is a graph illustrating the relationship between a growth time (min) and the surface roughness (Rq) of the crystal growth surface, regarding the SiC single crystals 1a and 1b produced in the first embodiment.

Fig. 57 is an explanatory drawing schematically illustrating the relationship between the growth thickness of a SiC single crystal layer at the time point when conversion of TSD occurs and the length of a defect that is generated by the conversion of TSD.

Fig. 58 is a graph illustrating the relationship between a conversion ratio (%) of TSD and a growth thickness d.

Fig. 59 is a graph illustrating the relationship between a conversion ratio (%) of TED and a growth thickness d.

Fig. 60 is a graph illustrating the relationship between a conversion ratio (%) of TSD, a conversion ratio (%) of TED and a growth thickness d.

[Description of Embodiments]

A crystal producing apparatus can be used as an apparatus for producing various types of crystals. Particularly, the apparatus can be used as an apparatus for producing various single crystals represented by a SiC single crystal, a sapphire single crystal, and a silicone single crystal. Crystals produced by the crystal producing apparatus can be implemented by a combination of a seed crystal and a raw material solution accordingly.

For example, in a case of producing a SiC single crystal, a solution containing silicon and carbon is used as the raw material solution. The seed crystal is brought into contact with the raw material solution (SiC solution) so that a solution in the vicinity of at least the seed crystal is in a supercooled state. This causes the C concentration of the raw material solution to be in a supersaturated state in the vicinity of the seed crystal, and thus the SiC single crystal is grown (primarily epitaxial growth) on the seed crystal. In a liquid phase growth method, crystal growth proceeds in an environment close to a thermal equilibrium state, and thus it is possible to obtain a good quality SiC single crystal in which the density of defects such as stacking faults is low. In addition, the material of the raw material solution is not particularly limited, and a general material may be used. For example, as a Si source of the SiC solution, Si or a Si alloy may be used. Specifically, an alloy solution in which Si is primarily contained and at least one type selected from the group consisting of Ti, Cr, Sc, Ni, Al, Co, Mn, Mg, Ge, As, P, N, O, B, Dy, Y, Nb, Nd, and Fe is added may be used. As a C source of the SiC solution, a solid carbide such as graphite, glassy carbon, and SiC, hydrocarbon gas such as methane, ethane, propane, and acetylene, and at least one type selected from carbides of the following elements X (X=Li, Be, B, Na, Mg, Al, Ca, Sc, Ti, V, Cr, Mn, Fe, Co, Ni, Br, Sr, Y, Zr, Nb, Mo, Ba, Hf, Ta, W, La, Ce, Sm, Eu, Ho, Yb, Th, U, or Pu) may be used. In addition, as a SiC seed crystal, various crystal polymorphs represented by 4H-SiC, 6H-SiC, and 3C-SiC may be used. However, as described later, in a case of producing a SiC single crystal having a small number of edge dislocations, 4H-SiC or 6H-SiC needs to be used as the SiC seed crystal.

In the crystal producing apparatus, the flow of the raw material solution may be convection or may also be forced flow. That is, the convection of the raw material solution may be caused by forming a temperature gradient or the like in the raw material solution. In this case, as a solution flowing element, for example, a heater may be used. Otherwise, the raw material solution may be forced to flow by an external force. For example, when an external force is added to the raw material solution to a degree at which the above-mentioned convection is negated, the raw material solution can be forced to flow. A method of generating the forced flow of the raw material solution is not particularly limited. For example, in a case where crystal growth is performed in the raw material solution accommodated in a container such as a crucible, the container may be caused to rotate or vibrate by applying an external force to the container such that the external force is indirectly applied to the raw material solution in the container, thereby generating forced flow. Otherwise, a crystal holding element for holding the seed crystal may be moved in the raw material solution such that an external force is directly applied to the raw material solution, thereby generating forced flow. Alternatively, a magnetic field may be directly applied to the raw material solution such that the raw material solution is forced to flow. Furthermore, a stirring bar may be inserted into the raw material solution such that the raw material solution is stirred by rotating the stirring bar or the like. Here, "the raw material solution flows" can be rephrased as "at least one of the raw material solution and the seed crystal holding element is changed in position relative to the other". That is, crystal growth can also be performed while changing the positions of the raw material solution and the seed crystal relative to each other by changing the position of the seed crystal holding element.

In a SiC single crystal producing method of the present invention, the flow of the raw material solution indicates forced flow other than convection. That is, in a liquid phase growth method, a temperature gradient or the like is generally formed in the raw material solution. Therefore, even in a case where the raw material solution is not forced to flow by an external force, there may be cases where convection of the raw material solution occurs. In the producing method of the present invention, the raw material solution is forced to flow to a degree at which the convection is negated. A method of generating the forced flow of the raw material solution is not particularly limited. For example, in a case where crystal growth is performed in the raw material solution accommodated in a container such as a crucible, the container may be caused to rotate or vibrate by applying an external force to the container such that the external force is indirectly applied to the raw material solution in the container, thereby generating forced flow. Otherwise, a magnetic field may be directly applied to the raw material solution such that the raw material solution is forced to flow.

According to the producing method of the present invention, by causing the raw material solution to flow along the direction opposite to the step developing direction at the SiC single crystal, at least a portion of the step bunchings that exist on the crystal growth surface is removed, and thus it is possible to substantially smoothen the crystal growth surface. In addition, by causing the flowing direction of the raw material solution to be a direction along the step developing direction of the SiC single crystal, step bunchings are generated, and thus it is possible to form steps having great heights on the crystal growth surface. However, in the specification, "causing the flowing direction of the raw material solution to be a direction along the step developing direction of the single crystal" means causing the flowing direction of the raw material solution to be a direction parallel to or substantially parallel to the step developing direction. The crossing angle between the flowing direction of the raw material solution and the step developing direction may be within $\pm 15°$. The crossing angle between the flowing direction of the raw material solution and the step developing direction is preferably within $\pm 10°$, and more preferably within $\pm 5°$.

(First Embodiment)

Hereinafter, a crystal producing method which uses a specific example of a crystal producing apparatus, which will be described below, is referred to as a crystal producing method of the first embodiment.

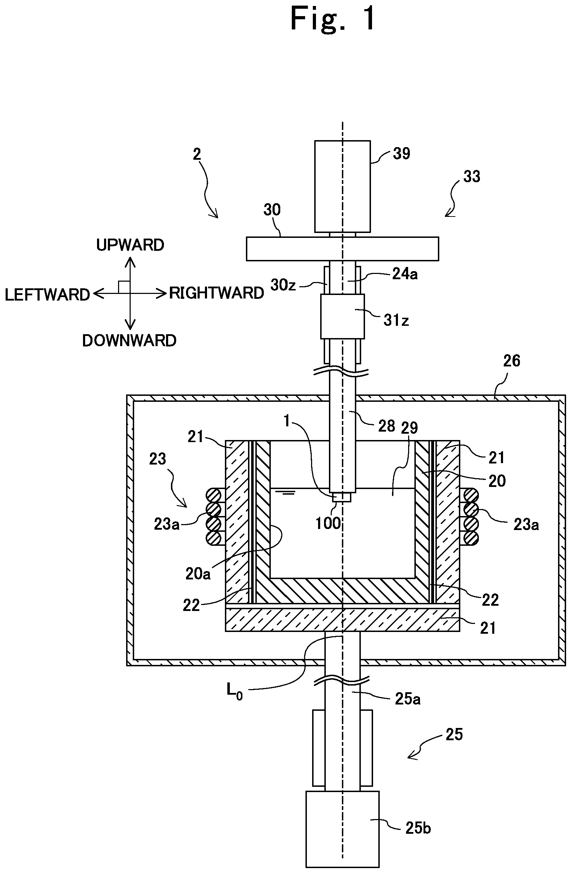

The crystal producing apparatus used in the first embodiment includes a high-frequency heating graphite hot zone furnace. An explanatory drawing schematically illustrating the crystal producing apparatus is illustrated in Fig. 1. A crystal producing apparatus 2 includes a carbon crucible 20 which is open upward, a heat insulating material 21 which covers the side surface and the bottom surface of the crucible 20, a hot wall 22 which is interposed between the crucible 20 and the heat insulating material 21, a heating element 23 which is disposed on the outer peripheral side of the heat insulating material 21 and heats the crucible 20, a crystal holding element 3 which holds a seed crystal, a solution flowing element 25 which rotates the crucible 20, and a chamber 26 which accommodates these elements. The crucible 20 corresponds to the liquid tub of the crystal producing apparatus used in the present invention and functions as a C source which supplies carbon to the raw material solution (a SiC solution 29). The crucible 20 has a substantially cylindrical shape having a bottom and an open top. The inner diameter of the crucible 20 is 45 mm and the depth thereof is 50 mm. The heating element 23 is an induction heating type heater. The heating element 23 includes a coil-like conducting wire 23a, and a lead wire (not illustrated) which connects the conducting wire 23a to a power source (not illustrated). The conducting wire 23a is wound around the outside of the heat insulating material 21 and forms induction heating coils coaxially with the crucible 20. The crystal holding element 3 includes a dipping shaft portion 24a having a rod shape, a z-direction guide portion 30z which guides the dipping shaft portion 24a in the longitudinal direction thereof (up and down directions in Fig. 1, that is, z-axis direction), an x-direction guide portion 30x which guides the dipping shaft portion 24a in a horizontal direction (left and right directions in Fig. 1, that is, x-axis direction), a y-direction guide portion 30y which guides the dipping shaft portion 24a in a horizontal direction (forward and inward directions with respect to Fig. 1, that is, y-axis direction), and a dipping shaft driving portion 39 which drives the dipping shaft portion 24a to rotate. Among these, the x-direction guide portion 30x, the y-direction guide portion 30y, and the z-direction guide portion 30z correspond to a guide element 33 in the crystal producing apparatus used in the present invention. The diameter of the dipping shaft portion 24a is 10 mm, and a holding portion 28 which can hold a seed crystal 1 is formed in one end portion of the dipping shaft portion 24a in the longitudinal direction thereof (the lower end portion in Fig. 1). The crystal holding element 3 is held by the above-mentioned guide element 33.

In the crystal producing apparatus, crystal growth is performed by dipping the seed crystal 1 in the SiC solution 29 in the crucible 20 and pulling the seed crystal 1 on the basis of a top seeded solution growth (TSSG) method.

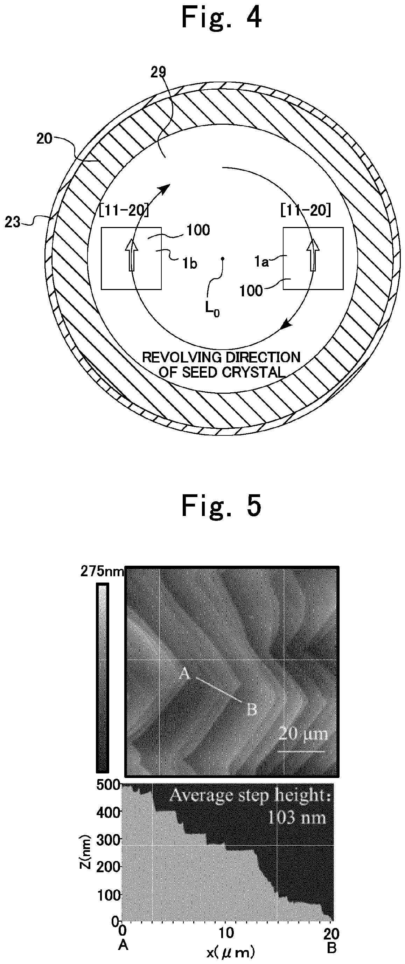

Specifically, the crucible 20 was rotated in one direction by the solution flowing element 25. The solution flowing element 25 is constituted by a rotating shaft portion 25a which is integrated with the center of the crucible 20 and a motor 25b which is integrated with the rotating shaft portion 25a. As illustrated in Fig. 4, the flow of the SiC solution 29 was formed in one direction as indicated by arrow in the figure in the crucible 20. More specifically, Si (having a purity of 11 N, manufactured by Tokuyama Corporation) in the carbon crucible 20 was heated by the heating element 23 to allow C contained in the crucible 20 to be eluted into the Si melt in the crucible 20, thereby obtaining the SiC solution 29. In addition, as a pre-treatment, each of the Si seed crystal and Si was subjected to ultrasonic cleaning in advance in methanol, acetone, and purified water (18 MΩ/cm).

The setting temperature of the heating element 23 in the crystal producing apparatus 2 was 1700°C, and a temperature gradient of 21°C/cm was formed in the crucible 20 in the up and down directions of Fig. 1 (a direction between the liquid surface and the bottom surface of the crucible 20). In a state where the temperature gradient was formed in the SiC solution 29 in the crucible 20 as described above, the dipping shaft portion 24a which held the SiC seed crystal 1 (hereinafter, simply referred to as the seed crystal 1) was inserted into the crucible 20 while supplying high-purity argon gas (99.9999% by volume) into the chamber.

The crystal holding element 3 includes the dipping shaft portion 24a and the guide element 33 illustrated in Fig. 1. More specifically, the dipping shaft portion 24a is held by the guide element 33 and is movable with respect to the radial direction of the crucible 20 and a rotational axis $L_0$ direction such that the seed crystal 1 can be disposed inside the crucible 20 over substantially the entire region thereof. The guide element 33 includes a substantially plate-like xy table 30 which is disposed above the crucible 20, the x-direction guide portion 30x which is attached to the xy table 30, the y-direction guide portion 30y which is attached to the x-direction guide portion 30x, and the z-direction guide portion 30z which is attached to the xy table 30.

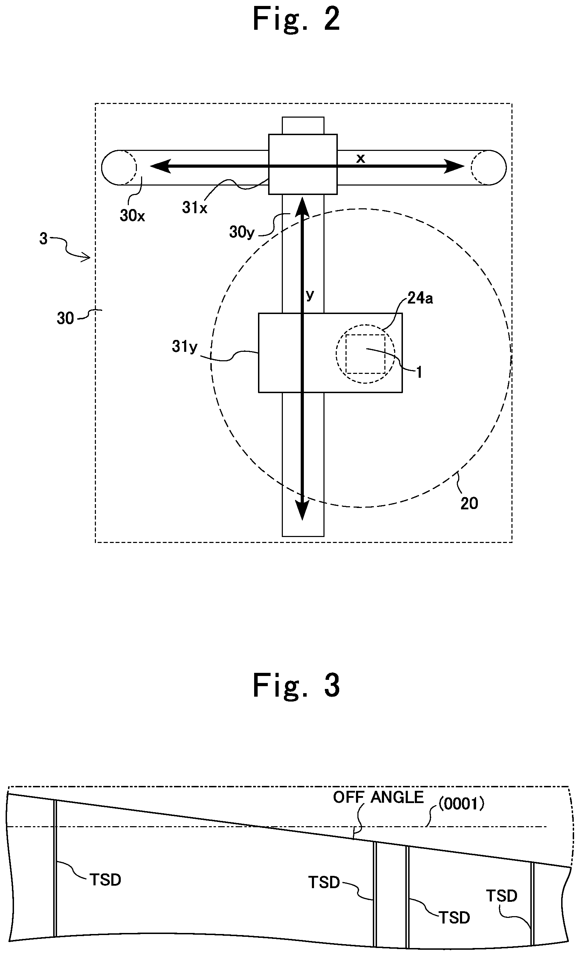

As illustrated in Fig. 2, each of the x-direction guide portion 30x and the y-direction guide portion 30y has substantially a bar shape. The x-direction guide portion 30x is fixed to the xy table 30. One end portion of the y-direction guide portion 30y is slidably attached to the x-direction guide portion 30x. Therefore, the y-direction guide portion 30y can slide along the longitudinal direction of the x-direction guide portion 30x (the arrow x-direction of Fig. 2). An x-direction driving portion 31x is interposed between the y-direction guide portion 30y and the x-direction guide portion 30x. The x-direction driving portion 31x includes a first motor (not illustrated) and a first transmission mechanism (not illustrated) which converts rotational motion of the first motor into linear motion in the x direction to be transmitted to the y-direction guide portion 30y, thereby enabling the y-direction guide portion 30y to automatically slide in the x direction.

The dipping shaft portion 24a is attached to the y-direction guide portion 30y. The dipping shaft portion 24a can slide along the longitudinal direction of the y-direction guide portion 30y (the arrow y-direction of Fig. 2). A y-direction driving portion 31y is interposed between the y-direction guide portion 30y and the dipping shaft portion 24a. The y-direction driving portion 31y includes a second motor (not illustrated) and a second transmission mechanism (not illustrated) which converts rotational motion of the second motor into linear motion in the y direction to be transmitted to the dipping shaft portion 24a, thereby enabling the dipping shaft portion 24a to automatically slide in the y direction.

The z-direction guide portion 30z is attached to the xy table 30. The z-direction guide portion 30z can slide along the z direction (the up and down directions of Fig. 1). A z-direction driving portion 31z is interposed between the xy table 30 and the z-direction guide portion 30z. The z-direction driving portion 31z includes a third motor (not illustrated) and a third transmission mechanism (not illustrated) which converts rotational motion of the third motor into linear motion in the z direction to be transmitted to the xy table, thereby enabling the xy table to automatically slide in the z direction. In addition, the dipping shaft portion 24a, the x-direction guide portion 30x, and the y-direction guide portion 30y follow the xy table 30 and slide vertically.

The longitudinal direction x of the x-direction guide portion 30x and the longitudinal direction y of the y-direction guide portion 30y are directions that intersect each other (directions that are substantially perpendicular to each other in the first embodiment), and the dipping shaft portion 24a is freely movable on a plane parallel to the xy table 30, that is, on the xy plane. The longitudinal direction of the dipping shaft portion 24a is a direction that intersects the longitudinal direction y of the y-direction guide portion 30y and the longitudinal direction x of the x-direction guide portion 30x (a direction that is substantially perpendicular thereto in the first embodiment), and as described above, the dipping shaft portion 24a can slide in the height direction thereof (the depth direction of the crucible 20: the z-axis direction). Therefore, the seed crystal 1 held by the dipping shaft portion 24a is movable in the crucible 20 in the x-axis direction and the y-axis direction and is also movable in the direction substantially perpendicular to the xy table (the z-axis direction, that is, the up and down directions illustrated in Fig. 1). That is, in the crystal producing apparatus, the seed crystal 1 can be disposed inside the crucible 20 over the entire region thereof. In addition, the dipping shaft portion 24a is movable on the xy plane in an arc direction around the rotational axis $L_0$ of the crucible 20 by the x-direction driving portion 31x, the y-direction driving portion 31y, and the z-direction driving portion 31z. In other words, the dipping shaft portion 24a can revolve around the rotational axis $L_0$ of the crucible 20 on the xy plane. That is, the guide element 33 in the crystal producing apparatus can set the orientation of the crystal growth surface of the seed crystal 1 with respect to the flowing direction of the raw material solution 29 to be in a range of 360°.

Furthermore, the motor 39 is attached to the dipping shaft portion 24a. The motor 39 moves in the x-axis direction, the y-axis direction, and the z-axis direction along with the dipping shaft portion 24a. The motor 39 can drive the dipping shaft portion 24a to rotate. In other words, the dipping shaft portion 24a was rotate on own axis. Therefore, in the crystal producing apparatus, by allowing the dipping shaft portion 24a to rotate (revolve and/or rotate on own axis), the raw material solution (the SiC solution) 29 can be allowed to flow. That is, the motor 39, the x-direction driving portion 31x, the y-direction driving portion 31y, the z-direction driving portion 31z, and the dipping shaft portion 24a also function as the solution flowing element.

As the seed crystal 1, 4H-SiC single crystal (10 mm × 10 mm × 0.35 mm thick) produced by a vapor phase growth method (sublimation method) was used. As illustrated in Fig. 3, an offset surface directed in a [11-20] direction was cut from a crystal growth surface 100 of the seed crystal 1, that is, a (0001) plane. The off angle at this time was 1.25°. The seed crystal 1 was attached to the holding portion 28, and the crystal growth surface 100 formed in the seed crystal 1 at the off angle was caused to face the SiC solution 29 in the crucible 20. In addition, the dipping shaft portion 24a was allowed to advance toward the inside of the crucible 20 so that the seed crystal 1 was dipped in the SiC solution 29. As the SiC solution 29 was cooled in the vicinity of the seed crystal 1 where the temperature was low, SiC crystal was grown on the surface of the seed crystal 1. During the crystal growth, the dipping shaft portion 24a was allowed to rotate (rotate on own axis and revolve) by the solution flowing element 25. Specifically, the dipping shaft portion 24a autorotated to allow the [11-20] direction of the seed crystal 1 to be continuously directed in the circumferential direction of a circle around the $L_0$ while revolving around the rotational axis $L_0$ illustrated in Fig. 4. Accordingly, the SiC solution 29 flowed relative to the crystal growth surface 100 of the seed crystal 1. The flow of the SiC solution 29 mentioned here is, more specifically, shearing flow that occurs due to the relative motion between the crystal growth surface 100 of the seed crystal 1 and the SiC solution 29 at the interface of the two. In addition, in a case where the seed crystal 1 is allowed to revolve in the arrow direction of Fig. 4 (clockwise), the flowing direction of the SiC solution 29 relative to the seed crystal 1 becomes a counterclockwise direction. As illustrated in Fig. 4, in a case where a seed crystal 1a is allowed to rotate such that the [11-20] direction of the seed crystal 1a is directed toward the rear side of the advancing direction at all time, the SiC solution 29 flows along the [11-20] direction with respect to the seed crystal 1a. On the other hand, in a case where a seed crystal 1b is allowed to rotate on own axis such that the [11-20] direction is directed toward the front side of the advancing direction at all time, the SiC solution 29 flows in a direction opposite to the [11-20] direction with respect to the seed crystal 1b. The seed crystal 1 is disposed on the outside of the flow center $L_0$ of the SiC solution 29 in the radial direction.

However, as described above, the off angle directed in the [11-20] direction is formed at the surface of the seed crystal 1. Therefore, the step developing direction of the SiC single crystal grown on each seed crystal 1 is guided to the [11-20] direction. By appropriately setting the position of the seed crystal 1 in the crucible 20, the flowing direction of the SiC solution 29 with respect to the step developing direction can be appropriately changed. That is, as illustrated in Fig. 4, the SiC solution 29 flows in substantially the same direction as the step developing direction in the vicinity of the seed crystal 1a, and the SiC solution 29 flows in the direction substantially opposite to the step developing direction in the vicinity of the seed crystal 1b. In addition, in the specification, "causing the flowing direction of the raw material solution to be a direction along the step developing direction of the single crystal" means causing the flowing direction of the raw material solution to be a direction parallel to or substantially parallel to the step developing direction. The crossing angle between the flowing direction of the raw material solution and the step developing direction may be within ±15°. The crossing angle between the flowing direction of the raw material solution and the step developing direction is preferably within ±10°, and more preferably within ±5°.

Each of the x-direction guide portion 30x, the y-direction guide portion 30y, and the dipping shaft portion 24a is graduated along the longitudinal direction. By the graduations of the x-direction guide portion 30x, the y-direction guide portion 30y, and the dipping shaft portion 24a, the coordinates of the dipping shaft portion 24a, further, the seed crystal 1 fixed to the dipping shaft portion 24a in the crucible 20 can be perceived, and the seed crystal 1 can be disposed at a expected position in the crucible 20 with high reproducibility.

The flowing direction and the flow velocity of the SiC solution in the crucible 20 can be calculated on the basis of, for example, the rotation frequency of the crucible 20, the amount and the temperature of the SiC solution, and the like. In addition, by appropriately adjusting the positions of the dipping shaft portion 24a and the seed crystal 1 on the basis of the detected or calculated flowing direction of the SiC solution, the step developing direction of the SiC single crystal on the seed crystal 1 and the flowing direction of the SiC solution can be allowed to be the same direction or opposite directions to each other.

The step developing direction of the SiC single crystal on the SiC seed crystal 1a and the flowing direction of the SiC solution 29 were allowed to be substantially the same direction. In addition, the step developing direction of the SiC single crystal on the SiC seed crystal 1b and the flowing direction of the SiC solution 29 were allowed to be substantially opposite directions to each other. Crystal growth was continuously performed in this state to form SiC single crystals on the crystal growth surfaces 100 of the seed crystals 1a and 1b at a lower temperature than that of the SiC solution 29.

The growth temperature at this time was 1700°C. The flow velocity of the SiC solution 29 was 8.6 cm/s. In addition, in the crystal producing apparatus, the flow velocity of the raw material solution is not particularly limited.

After 1 hour from the start of the growth (that is, after the start of the contact between the seed crystals 1 and the SiC solution 29), the dipping shaft portion 24a was moved upward to pull the two seed crystals 1 from which crystals were grown (that is, SiC single crystals), from the SiC solution 29. The two SiC single crystals 10 that were pulled were etched by a mixed liquid of $HNO_3$ and HF ($HNO_3$ : HF = 2 : 1) to remove the SiC solution 29 that remained on the surfaces thereof. By the above process, the SiC single crystals were obtained. Among these, the SiC single crystal which used the seed crystal 1a is referred to as a SiC single crystal 1a, and the SiC single crystal which used the seed crystal 1b is referred to as a SiC single crystal 1b.

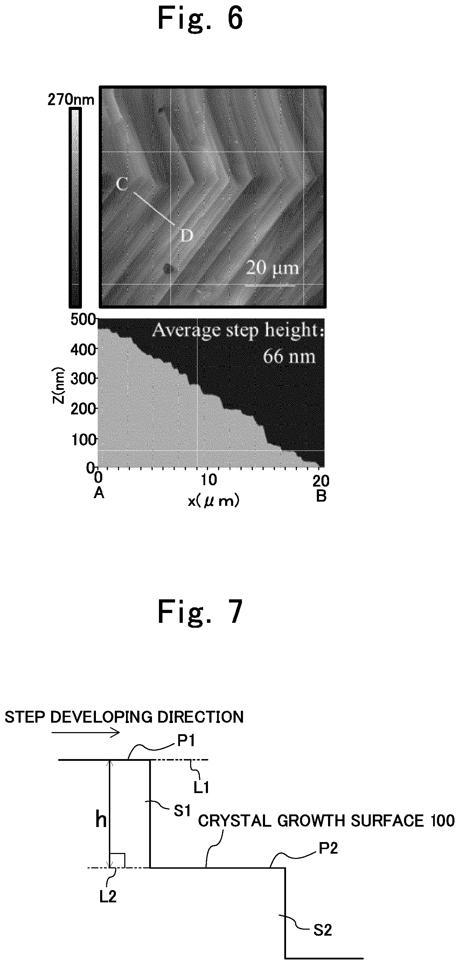

Steps were developed on any of the SiC single crystal 1a and the SiC single crystal 1b. The heights of the steps formed on the SiC single crystal 1a and the SiC single crystal 1b were measured by using an atomic force microscope (AFM). The measurement results are illustrated in Figs. 5 and 6. Specifically, the upper figure in Fig. 5 illustrates the height distribution of the surface of the SiC single crystal 1a, and the lower figure in Fig. 5 illustrates the profile in the height direction between A-B in the upper figure. The upper figure in Fig. 6 illustrates the height distribution of the surface of the SiC single crystal 1b, and the lower figure in Fig. 6 illustrates the profile in the height direction between C-D in the upper figure. As illustrated in Fig. 5, in the SiC single crystal 1a in which the flowing direction of the SiC solution and the step developing direction were substantially the same direction, the average height of the steps was 103 nm and macrosteps having great step heights were formed. Contrary to this, as illustrated in Fig. 6, in the SiC single crystal 1b in which the flowing direction of the SiC solution and the step developing direction were substantially opposite directions to each other, the average height of the steps was 66 nm and large steps as in the SiC single crystal 1a were not formed.

The height h of the step in the specification indicates the distance between terrace surfaces P1 and P2 illustrated in Fig. 7. More specifically, the height of the step may be described as follows. As illustrated in Fig. 7, the terrace surface of an arbitrary step S1 (that is, the leading end surface of the SiC seed crystal itself in the crystal growth direction) is referred to as a terrace surface P1 and a straight line that passes through the terrace surface P1 is referred to as a straight line L1. In addition, the terrace surface of another step S2 that is adjacent to the leading side of the step S1 in the step developing direction is referred to as P2, and a straight line that passes through the terrace surface P2 is referred to as a straight line L2. The height of the step S1 in this case corresponds to the distance between the straight line L1 and the straight line L2. In the specification, a step having a height of greater than 70 nm is referred to as a macrostep. In a bunching process, when macrosteps are formed on the SiC seed crystal, as described above, threading screw dislocations can be converted. In addition, depending on the step developing direction, threading edge dislocations can also be converted.

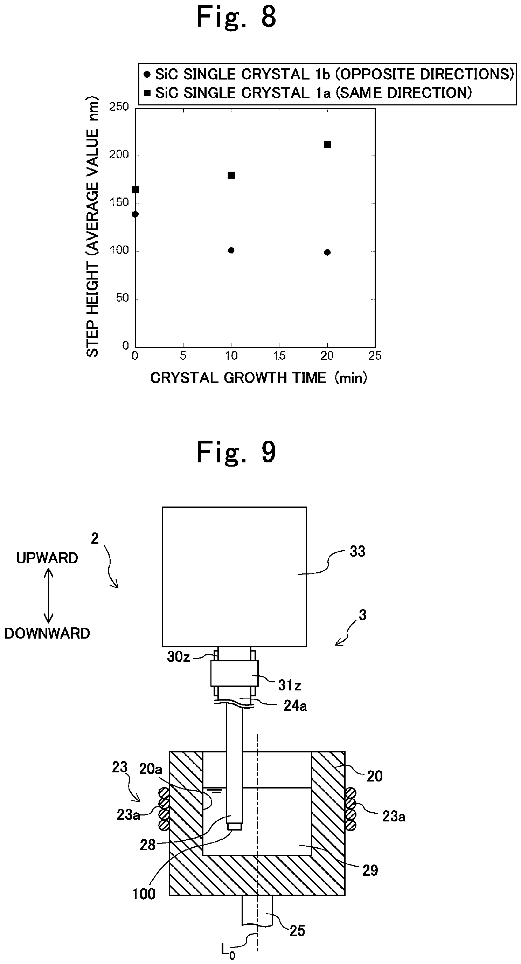

A graph illustrating changes in the step heights of the SiC single crystals 1a and 1b with time during the crystal growth is illustrated in Fig. 8. As illustrated in Fig. 8, regarding the SiC single crystal 1a in which the flowing direction of the SiC solution 29 and the step developing direction were the same direction, the step height was increased as the crystal growth time had elapsed (that is, the crystal growth had proceeded). That is, step bunching had proceeded and steps (macrosteps) having great step heights were formed. On the other hand, regarding the SiC single crystal 1b in which the flowing direction of the SiC solution 29 and the step developing direction were opposite directions to each other, the step height was decreased as the crystal growth time had elapsed. That is, step bunching was released and the crystal growth surface was smoothened. As described above, by using the crystal growth apparatus, the formation of step bunchings on the crystal growth surface could be allowed to proceed, and thus a single crystal could be grown while forming macrosteps. In addition, a single crystal in which defects such as threading screw dislocations were converted into defects of the basal plane could be obtained. Furthermore, by using the crystal growth apparatus, the degree of step bunching on the crystal growth surface could be reduced (the step bunching was released) and the crystal growth surface could be smoothened.

In the first embodiment, the SiC solution 29 (that is, the raw material solution) is allowed to flow by rotating the dipping shaft portion 24a. However, for example, by rotating the crucible 20, the SiC solution 29 can also be allowed to flow. Otherwise, by allowing the dipping shaft portion 24a to reciprocate in the SiC solution 29, the SiC solution 29 can also be allowed to flow. In the first embodiment, adjusting the position of the dipping shaft portion 24a in the crucible 20 is automatically performed but may also be performed manually.

In the first embodiment, as the crystal holding element, elements capable of disposing the seed crystal in the x, y, and z directions are used. However, in the crystal producing apparatus, the seed crystal may not be moved in the z-axis direction, that is, the depth direction of the raw material solution. In addition, the x-axis direction and the y-axis direction may be two directions on a plane perpendicular to the z-axis and may not be perpendicular to each other. Furthermore, in the crystal producing apparatus, the crystal holding element may change the position of the seed crystal in at least a partial region on the xy plane, and the seed crystal may also be moved only linearly on the xy plane. However, in consideration of versatility of the crystal producing apparatus and the like, a region in which the seed crystal moves is preferably as wide as possible.

In addition, in the crystal producing apparatus, the crystal holding element holds only a single seed crystal but may also hold two or more seed crystals simultaneously. For example, in a case where the two seed crystals 1a and 1b are simultaneously held at the positions illustrated in Fig. 4, the crystal growth surfaces 100 of the two seed crystals 1a and 1b may be simultaneously directed in directions that are 180° different from each other with respect to the flowing direction of the raw material solution.

However, as a method of setting the orientations of the crystal growth surfaces of the seed crystals to be two directions that are 180° different from each other with respect to the flowing direction of the raw material solution, other methods than the method (illustrated in Fig. 4) of changing the position of the seed crystal in the liquid tub may also be used. For example, the flowing direction of the raw material solution may be changed to the opposite direction. Furthermore, the direction of the crystal growth surface of the seed crystal with respect to the flowing direction of the raw material solution may be set to another direction, in addition to the two directions that are 180° different from each other. That is, the crystal producing apparatus is able to set the directions of the crystal growth surfaces of the seed crystals with respect to the flowing direction of the raw material solution to be three or more different directions.

In addition, as described above, when the crystal producing apparatus is used, macrosteps can be developed when the SiC single crystal is grown. When the macrosteps are developed on the defects (for example, threading screw dislocations, threading edge dislocations, and the like) that extend in the crystal growth direction, such defects can be converted into defects which are substantially parallel to the basal plane (stacking faults of the basal plane and basal plane dislocations) and the like. That is, by producing the SiC single crystal in the above-described method of the present invention, step bunching is allowed to occur on the crystal growth surface of the SiC single crystal. Furthermore, the SiC single crystal is grown while developing the macrosteps, and thus it is possible to obtain a SiC single crystal in which the number of threading screw dislocations and the like is reduced.

(Second Embodiment)

A crystal producing apparatus used in a second embodiment is substantially the same as the crystal producing apparatus used in the first embodiment, and the leading end of the dipping shaft portion is disposed closer to the outside in the radial direction of the crucible than the rotational axis of the crucible. An explanatory drawing schematically illustrating the crystal producing apparatus used in the second embodiment is illustrated in Fig. 9.

Similarly to the crystal producing apparatus of Example 1, the crystal producing apparatus 2 includes a crucible 20, a heating element 23, a crystal holding element 3, a solution flowing element 25, and a chamber (not illustrated) which accommodates these elements. A holding portion 28 which can hold a SiC seed crystal 1 is formed in the leading end of a dipping shaft portion 24a. The crystal holding element 3 is held by a guide element 33. As illustrated in Fig. 9, the holding portion 28 is disposed closer to the outside in the radial direction of the crucible 20 than a rotational axis $L_0$ of the crucible 20.

Even in the second embodiment, as in the first embodiment, crystal growth was performed by dipping the SiC seed crystal 1 in a raw material solution 29 in the crucible 20 and pulling the SiC seed crystal 1 by using the crystal producing apparatus 2 on the basis of a top seeded solution growth method.

Specifically, the crucible 20 was rotated in one direction by the solution flowing element 25 to form the flow of the raw material solution 29 in the crucible 20 in one direction as indicated by arrow in Fig. 4 as illustrated in Fig. 4 of the first embodiment. At this time, in the same method as that of the first embodiment, C contained in the crucible 20 was eluted into the Si melt in the crucible 20, thereby obtaining the SiC solution 29. The setting temperature of the heating element 23 in the second embodiment was 1700°C as in the first embodiment, and the temperature gradient in the crucible 20 was also the same as that of the first embodiment.

Hereinafter, a producing method of the second embodiment will be described.

In the second embodiment, two seed crystals 1 which were the same as those of the first embodiment were used. One of the two seed crystals 1 was attached to the holding portion 28 as illustrated in Fig. 9. As in the first embodiment, as the raw material solution 29 was cooled in the vicinity of the seed crystal 1 where the temperature was low, a SiC single crystal was grown on the surface of the seed crystal 1. Here, in the second embodiment, the crystal growth was performed on the basis of an accelerated crucible rotation technique. That is, the crucible 20 was rotated by the solution flowing element (crucible driving element) 25 during the crystal growth. Due to the rotation of the crucible 20, the raw material solution 29 in the crucible 20 was allowed to flow in the same direction as the rotation direction of the crucible 20 (Fig. 4). In addition, the seed crystal 1 disposed in the crucible 20 was disposed closer to the outside in the radial direction of the crucible 20 than the rotational axis $L_0$ of the crucible 20. Therefore, the raw material solution 29 flowed also in the vicinity of the crystal growth surface of the seed crystal 1.

As described above, an off angle directed in the [11-20] direction is formed at the surface of the seed crystal 1. Therefore, the step developing direction of the SiC single crystal grown on the seed crystal 1 is guided to the [11-20] direction. Crystal growth was separately performed on the two seed crystals 1. Regarding one seed crystal 1a, the raw material solution flowed in substantially the same direction as the step developing direction. Regarding the other seed crystal 1b, the raw material solution 29 flowed in the direction substantially opposite to the step developing direction. The rotational speed (maximum speed) of the crucible 20 at this time was about 20 rpm.

In the producing method of the second embodiment, crystal growth was continuously performed while allowing the step developing direction of the SiC single crystal on the SiC seed crystal 1a and the flowing direction of the raw material solution 29 to be substantially the same direction and allowing the step developing direction of the SiC single crystal on the SiC seed crystal 1b and the flowing direction of the raw material solution 29 to be substantially opposite directions to each other, such that SiC single crystals were grown on the crystal growth surfaces of the seed crystals 1a and 1b at a lower temperature than that of the raw material solution 29. The growth temperature at this time was 1700°C. The flow velocity of the raw material solution 29 was 8.6 cm/s.

After 20 minutes from the start of the growth (that is, after the start of the contact between the seed crystals 1 and the raw material solution 29), the dipping shaft portion 24a was moved upward by a dipping shaft driving portion to pull the two seed crystals 1 from which crystals were grown (that is, SiC single crystals 10), from the raw material solution 29. The pulled SiC single crystals 10 were etched by a mixed liquid of $HNO_3$ and HF ($HNO_3$ : HF = 2:1) to remove the raw material solution that remained on the surfaces thereof. By the above process, the SiC single crystals of the second embodiment were obtained. As in the SiC single crystals of the first embodiment, the heights of the steps in the two SiC single crystals obtained in the second embodiment were measured. The measurement method and the apparatus were the same as those of the first embodiment. As a result, similarly to the first embodiment, in the SiC single crystal in which the flowing direction of the raw material solution and the step developing direction were substantially the same direction, macrosteps were formed. Contrary to this, in the SiC single crystal in which the flowing direction of the raw material solution and the step developing direction were substantially opposite directions to each other, macrosteps were not formed.

However, as described above, when the SiC single crystal is grown, in a case where the macrosteps are developed on threading screw dislocations in the seed crystal, defects (for example, the threading screw dislocations, threading edge dislocations, and the like) that extend in the crystal growth direction can be converted into defects which are substantially parallel to the basal plane (stacking faults of the basal plane and basal plane dislocations) and the like. That is, in the SiC single crystal producing method of the present invention, by performing the crystal growth while allowing the raw material solution to flow along the step developing direction, step bunching is allowed to occur on the crystal growth surface of the SiC single crystal. Furthermore, macrosteps can be formed. In addition, by developing the macrosteps on the defects, it is possible to obtain a SiC single crystal in which the number of threading screw dislocations and the like is reduced. Thereafter, in the SiC single crystal producing method of the present invention, by performing the crystal growth while allowing the raw material solution to flow along the direction opposite to the step developing direction, it is possible to obtain a SiC single crystal in which the number of defects such as threading screw dislocations is reduced and the surface is smoothened. Moreover, in the crystal producing apparatus 2 used in the second embodiment, as in the crystal producing apparatus 2 used in the first embodiment, only a single portion (the holding portion 28) is provided to hold the seed crystal. However, in the crystal producing apparatus 2, a plurality of holding portions 28 may be provided. In this case, for example, when the flowing direction of the raw material solution 29 is allowed to be an opposite direction, the orientation of the crystal growth surface of the seed crystal 1 with respect to the flowing direction of the raw material solution 29 can be set to two directions that are 180° different from each other. In addition, as the SiC seed crystal 1, a SiC seed crystal in which macrosteps are formed in advance may also be used.

[Relationship between Step Height and Conversion Ratio of Threading Screw Dislocations]

(Test 1)

A SiC single crystal producing method of Test 1 is the same method as the SiC single crystal producing method of the second embodiment except that cutting is performed so that the off angle formed at the (0001) plane of the SiC seed crystal is 1.25°, and the raw material solution is forced to flow in one direction with respect to the crystal growth surface. That is, a crystal producing apparatus used in Test 1 is also the crystal producing apparatus used in the present invention. By the SiC single crystal producing method of Test 1, a SiC single crystal of Test 1 was obtained.

(Test 2)

A SiC single crystal producing method of Test 2 is the same method as the SiC single crystal producing method of Test 1 except that cutting is performed so that the off angle formed at the (0001) plane of the SiC seed crystal is 2°. By the SiC single crystal producing method of Test 2, a SiC single crystal of Test 2 was obtained.

(Test 3)

A SiC single crystal producing method of Test 3 is the same method as the SiC single crystal producing method of Test 1 except for the off angle. Specifically, the off angle formed at the seed crystal in Test 3 was 4°. By the SiC single crystal producing method of Test 3, a SiC single crystal of Test 3 was obtained.

(Test 4)

A SiC single crystal producing method of Test 4 is the same method as the SiC single crystal producing method of Test 1 except for the off angle. Specifically, the off angle formed at the seed crystal in Test 4 was 0.75°. By the SiC single crystal producing method of Test 4, a SiC single crystal of Test 4 was obtained.

(Evaluations)

[Conversion Ratio of Threading Screw Dislocations]

By using an X-ray topography method using synchrotron radiation X-rays, the SiC single crystals of Tests 1 to 3 were observed, and defects that had remained in each of the SiC single crystals were evaluated. In addition, evaluation of defects on the seed crystals before the crystal growth was performed in the same method. In the X-ray topography method, Photon factory BL-15C was used as a beam line. The wavelength was 0.150 nm, and the reflection surface was (11-28).

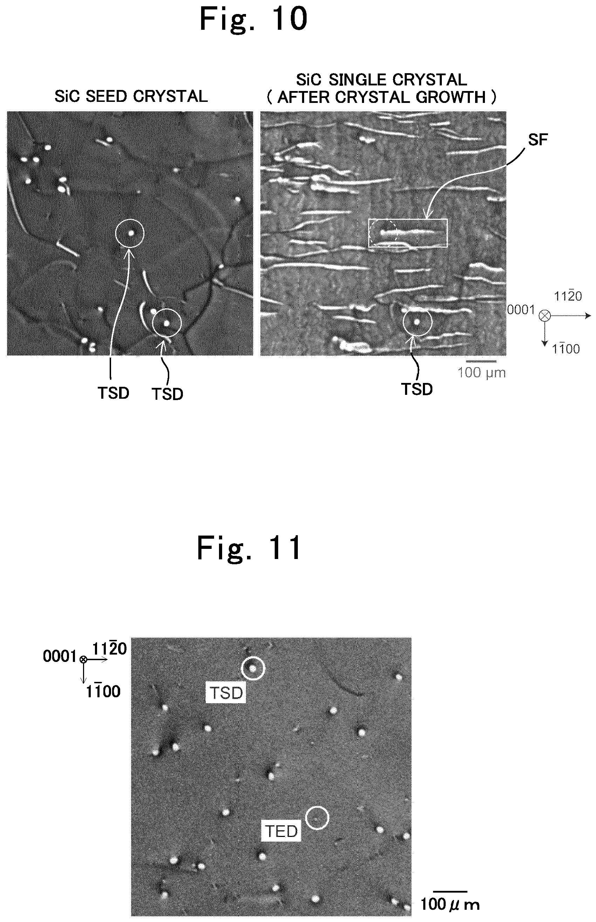

Fig. 10 is an X-ray topograph of the seed crystal and the SiC single crystal at an initial stage of the crystal growth according to the method of Test 1, which were taken at the same point. More specifically, the left image of Fig. 10 is an X-ray topograph of the seed crystal, and the right image of Fig. 10 is an X-ray topograph of the seed crystal of Test 1 at the initial stage of the crystal growth. In the seed crystal before the growth, there were a large number of threading screw dislocations indicated by dot-shaped contrasts. A fair number of threading screw dislocations TSD were converted into line-shaped contrasts that extend in the step developing direction in the crystal after the growth. From the result of TEM observation, it was apparent that the defects indicated by such contrasts were Frank type stacking faults which accompanied partial dislocations. From the result, it can be seen that, in the producing method of Test 1, the threading screw dislocations that are present in the seed crystal can be converted into the stacking faults of the basal plane.

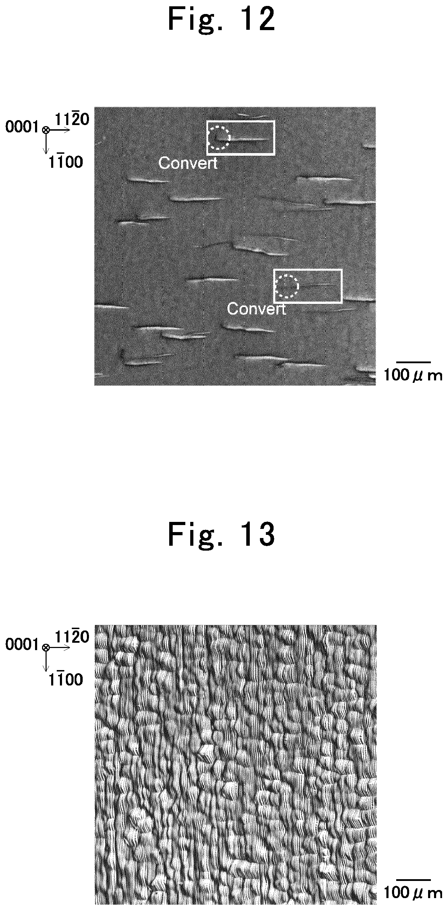

Figs. 11 to 13 are micrographs of the seed crystal, the SiC single crystal at an initial stage of the crystal growth according to the method of Test 3, and the SiC single crystal of Test 3, which were taken at the same point. More specifically, the image illustrated in Fig. 11 is an X-ray topograph of the seed crystal. The image illustrated in Fig. 12 is an X-ray topograph of the SiC single crystal of Test 3 at the initial stage of the crystal growth. The image illustrated in Fig. 13 is a Nomarski differential interference contrast micrograph of the SiC single crystal of Test 3.

As illustrated in Figs. 11 and 12, in the SiC single crystal of Test 3 in which the off angle was greater than that of Test 1, most of threading screw dislocations TSD at the initial growth stage were converted into stacking faults SF. In addition, as illustrated in Fig. 13, in the SiC single crystal obtained in the producing method of Test 3, a large number of level differences which were traces of the development of the steps were formed and most of the threading screw dislocations TSD and the stacking faults SF had disappeared. From the result, it can be seen that even in the producing method of Test 3 in which the off angle is great, the threading screw dislocations that are present in the seed crystal can be converted into the stacking faults of the basal plane.

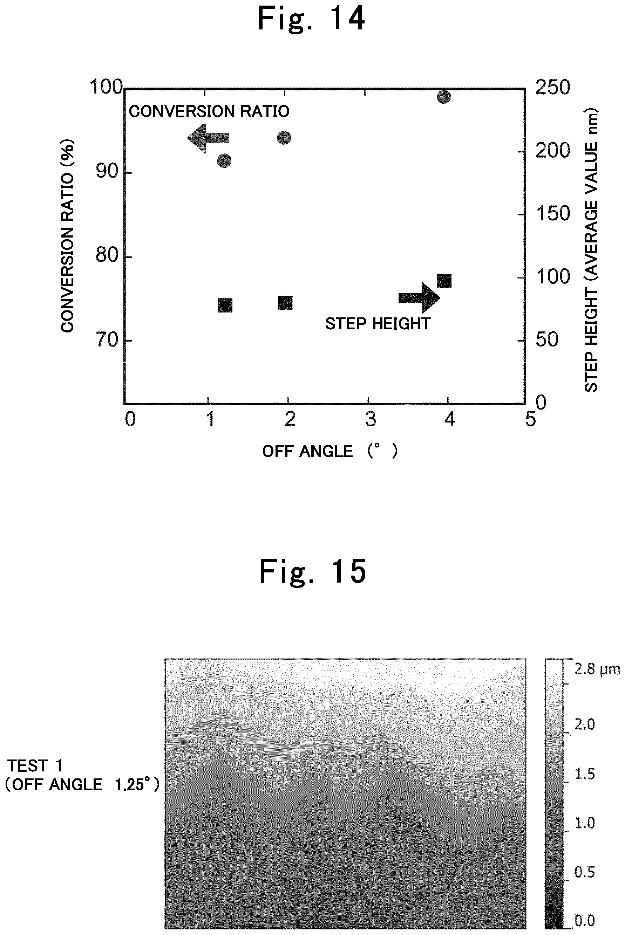

An arbitrary region of 1 mm × 5 mm selected from the X-ray topograph obtained in the above method was visually counted, and the number of threading screw dislocations in the seed crystal used in each test and the number of threading screw dislocations in the SiC single crystal obtained in each test were measured. In addition, the conversion ratio (%) of the threading screw dislocations in each test was calculated with respect to the number of threading screw dislocations in each seed crystal used in each test as 100% by number. The results are illustrated in Fig. 14.

As illustrated in Fig. 14, as the off angle increases, the conversion ratio of the threading screw dislocations into the stacking faults is increased.

[Relationship between Step Height and Off Angle]

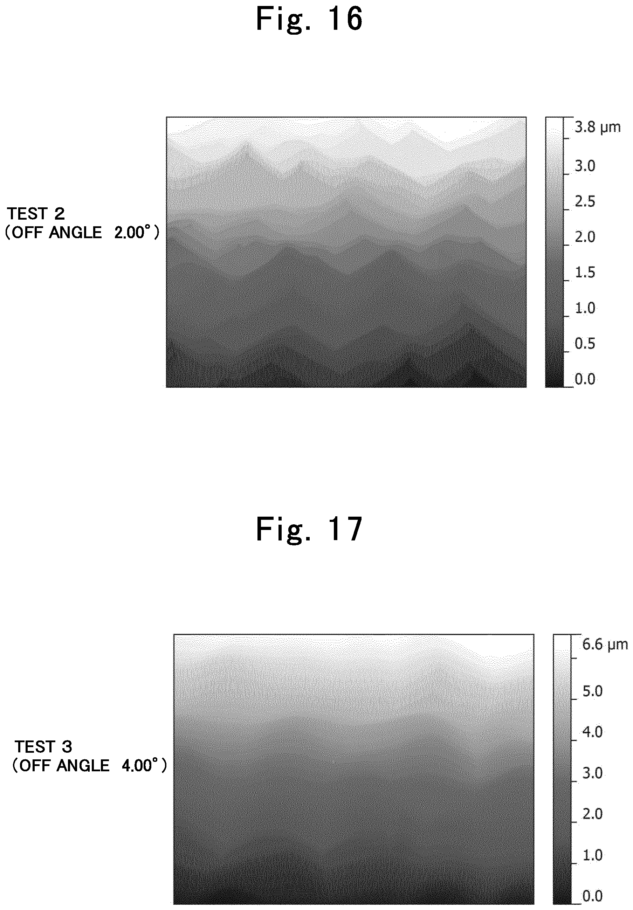

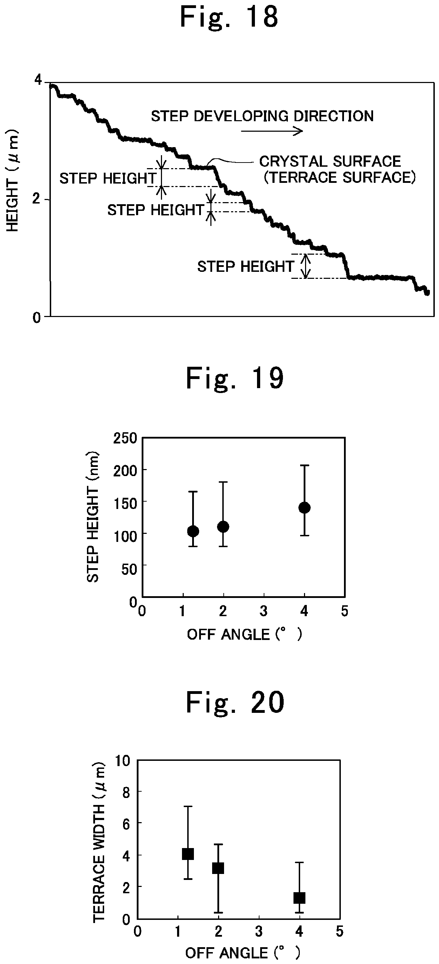

By using a confocal laser scanning microscope, the heights of the steps formed in the SiC single crystal obtained in each test were measured. Specifically, as the confocal laser scanning microscope, LEXT OLS-3100 made by Olympus Corporation was used, and each SiC single crystal was taken from the terrace surface side. A laser scanning micrograph of the SiC single crystal of Test 1 is illustrated in Fig. 15, a laser scanning micrograph of the SiC single crystal of Test 2 is illustrated in Fig. 16, and a laser scanning micrograph of the SiC single crystal of Test 3 is illustrated in Fig. 17. The light and shade of each image illustrated in Figs. 15 to 17 represent the heights of steps. The step developing direction indicates up and down directions (a direction from light color side to deep color side) in each figure. As illustrated in Figs. 15 to 17, a large number of step bunchings are formed in the SiC single crystals of Tests 1 to 3. In addition, from the fact that a large number of steps are arrayed in a streaked pattern, it can be seen that the steps are developed in the SiC single crystals. Furthermore, it can also be seen that the heights of the steps are in the order of Test 3 > Test 2 > Test 1. As an example, an explanatory drawing schematically illustrating the steps of the SiC single crystal obtained from the laser scanning micrograph of the SiC single crystal of Test 1 illustrated in Fig. 15 is illustrated in Fig. 18. As illustrated in Fig. 18, the heights of steps and terrace widths in the SiC single crystal can be read from the laser scanning micrograph. In the same manner, the heights of steps and terrace widths in the SiC single crystals of Tests 2 and 3 were read. The relationship between the step height and the off angle in each of the SiC single crystals of Tests 1 to 3 is illustrated in Fig. 19, and the relationship between the terrace width and the off angle in each of the SiC single crystals of Tests 1 to 3 is illustrated in Fig. 20. As illustrated in Fig. 19, as the off angle had increased, steps having greater step heights were formed. Therefore, it is thought that as the off angle increases, a SiC single crystal primarily containing steps having great step heights (macrosteps) can be obtained.

The relationship between the minimum value of the step height in each of the SiC single crystal which is illustrated in Fig.19 and the off angle formed at the seed crystal of each of Tests 1 to 3 is illustrated in Fig. 14 together with the conversion ratio of threading screw dislocations. As illustrated in Fig. 14, the conversion ratio of threading screw dislocations and the minimum value of the step height in the SiC single crystal have a positive correlation. Therefore, it can be seen that as the minimum value of the step height increases, the conversion ratio of threading screw dislocations increases. In the SiC single crystal of Test 1 in which the off angle was 1.25° and the minimum value of the step height was 80 nm, 90% or more of the threading screw dislocations were converted. In the SiC single crystal of Test 3 in which the off angle was 4° and the minimum value of the step height was 100 nm, 99% or more of the threading screw dislocations were converted. As described above, by forming macrosteps having great step heights, the conversion ratio of threading screw dislocation into stacking faults is significantly increased. In addition, based on the result, it can be said that by forming macrosteps having great step heights, the conversion ratio of threading edge dislocations into basal plane dislocations is also significantly increased. The details of the macrosteps will be described later.

In addition, in the SiC single crystal producing method of the present invention, not all the steps are macrosteps. When at least one macrostep is formed, the conversion ratio of threading screw dislocations is increased, and thus it is possible to obtain a SiC single crystal with a small number of threading screw dislocations. As a matter of course, when a large number of macrosteps are formed as described above (for example, in a case where the minimum value of the step height is 100 nm or greater as in Test 3), a SiC single crystal in which the number of threading screw dislocations is significantly reduced can be obtained. That is, according to the SiC single crystal producing method of the present invention, by appropriately adjusting the number or heights of macrosteps, it is possible to obtain a SiC single crystal with no threading screw dislocation. For reference, as illustrated in Fig. 20, as the off angle increases, the terrace width decreases.

The number of macrosteps is preferably as high as possible. This is because when a plurality of macrosteps are developed on a single threading screw dislocation, a frequency at which the threading screw dislocations are converted is increased. A preferable number of macrosteps can be represented as a preferable macrostep density on the basis of the following calculation.

As described above, almost 100% of the threading screw dislocations in the SiC single crystal of Test 3 were converted. The thickness of the SiC single crystal (the thickness of the grown crystal) was 20 $\mu$m. Since the minimum value of the height of the macrostep at this time was 100 nm (0.1 $\mu$m), it is thought that when a phenomenon in which the macrosteps are developed on the crystal growth surface occurs 200 or more times, almost all threading screw dislocations of the SiC single crystal are converted. In other words, it is thought that when macrosteps are developed on a single threading screw dislocation 200 or more times, the threading screw dislocation is almost certainly converted. Since the crystal growth surface in the SiC seed crystal of Test 3 was 1 cm $\times$ 1 cm, it can be said that a particularly preferable macrostep density (linear density) was 200 steps/cm or higher. In practice, when the linear density of the macrosteps is 100 steps/cm or higher, most of the threading screw dislocations are converted. That is, it can be said that a preferable linear density of the macrosteps is 100 steps/cm or higher. The linear density of the macrosteps is more preferably 250 steps/cm or higher, and even more preferably 500 steps/cm or higher. In addition, an average linear density $\rho$ of the macrosteps in the SiC single crystal in which the threading screw dislocations were converted was about 1000 steps/cm, the linear density $\rho$ of the macrosteps is particularly preferably 1000 steps/cm or higher, and even more preferably 2000 steps/cm or higher. The same is also applied to threading edge dislocations, which will be described later. That is, even in a case where conversion of threading edge dislocations is considered, the linear density of the macrosteps is particularly preferably 100 steps/cm or higher, more preferably 250 steps/cm or higher, and even more preferably 500 steps /cm or higher.

For reference, "the number of macrosteps" mentioned here means the number of macrosteps at an arbitrary time point during the crystal growth. The number of macrosteps approximates to the number of level differences in a streaked pattern remaining on the SiC single crystal. The number of level differences in a streaked pattern may be regarded as the number of steps. In addition, the size of the crystal growth surface in the SiC seed crystal approximates to the size of the crystal growth surface in the SiC single crystal. Therefore, by measuring the density of the level differences in the streaked pattern remaining in the crystal growth surface of the SiC single crystal, the density of the macrosteps can be measured. Furthermore, the number of level differences in the streaked pattern remaining in the crystal growth surface of the SiC single crystal can be measured by using a laser scanning microscope.

However, a preferable number or density of the macrosteps described above may also be expressed as follows.

It is assumed that the average height of the macrosteps is h (cm), the growth thickness of the SiC single crystal is t (cm), the linear density of the macrosteps, that is, the number of level differences in the streaked pattern per unit length (1 cm) is $\rho$ (1/cm), and the average interval $W_{ave}$ between the macrosteps is $1/\rho$ (cm).

A case where macrosteps are developed on a crystal growth surface is considered focusing on an arbitrary point A on the crystal growth surface. When a SiC single crystal is grown by a thickness of t, macrosteps pass through the point A n = t/h (times). In addition, in order to cause the macrosteps to pass through the point A n times, the macrosteps need to be developed from a position distant from the A by n $\times$ $W_{ave}$ (cm) toward the point A. That is, when the length of the SiC single crystal in a step developing direction is assumed to be y (cm), the growth by the thickness of t (cm) means a growth at a ratio of t/y of the length of the entire SiC seed crystal in the step developing direction.

When the number of times the macrosteps passes to convert threading screw dislocations is assumed to be N times, the SiC single crystal needs to be grown by a thickness of N $\times$ h. In addition, in order for the macrosteps to pass through the threading screw dislocations N times, a macrostep at a distance of N $\times$ $W_{ave}$ (cm) from a threading screw dislocation needs to pass through the threading screw dislocation. That is, the macrostep needs to be developed by N $\times$ $W_{ave}$ (cm) or greater.

An average linear density $\rho$ of the macrosteps is 1000 steps/cm. In addition, a preferable height of the macrosteps is 0.1 $\mu$m as described above. Therefore, in consideration of the above expression, in order for macrosteps to be developed on a single threading screw dislocation 100 or more times, the growth thickness of the SiC single crystal is preferably equal to or greater than 100 $\times$ 0.1 $\mu$m = 10 $\mu$m. A more preferable growth thickness thereof is equal to or greater than 20 $\mu$m. In addition, a preferable development distance of the macrostep is 100 $\times$ $W_{ave}$ = 100 $\times$ $1/\rho$ = 100 $\times$ 1/1000 = 1/10 cm = 1 mm. However, the preferable growth thickness and the preferable development distance of the macrostep described above is a preferable development distance for conversion of threading screw dislocations. Therefore, in order to obtain a SiC single crystal with a small number of threading screw dislocations (or with no threading screw dislocation), after crystal growth by the above-described preferable thickness (or after developing macrosteps by the above-described preferable distance), a SiC single crystal having a further necessary size may be grown.

In addition, in order to convert a larger number of threading screw dislocations, it is preferable that the macrosteps be continuously developed over a wide region. The overall length of the X-ray topograph illustrated in Fig. 11 is about 1000 $\mu$m. The macrosteps are formed over the entire region of this image, and the linear density thereof is in the above-described preferable range, that is, is equal to or higher than 100 steps/cm. Therefore, it can be said that the macrosteps are continuous over 1 mm or longer at a linear density of 100 steps/cm or higher (more preferably, 200 steps/cm). The length of the continuous macrosteps is preferably as long as possible. Therefore, it is thought that the macrosteps is preferably continuous over 3 mm or longer at a linear density of 100 steps/cm or higher, and is preferably continuous over 5 mm or longer.

The reason why a SiC single crystal with a small number of defects can be obtained by developing macrosteps as described above is not clear, but is presumed as follows.

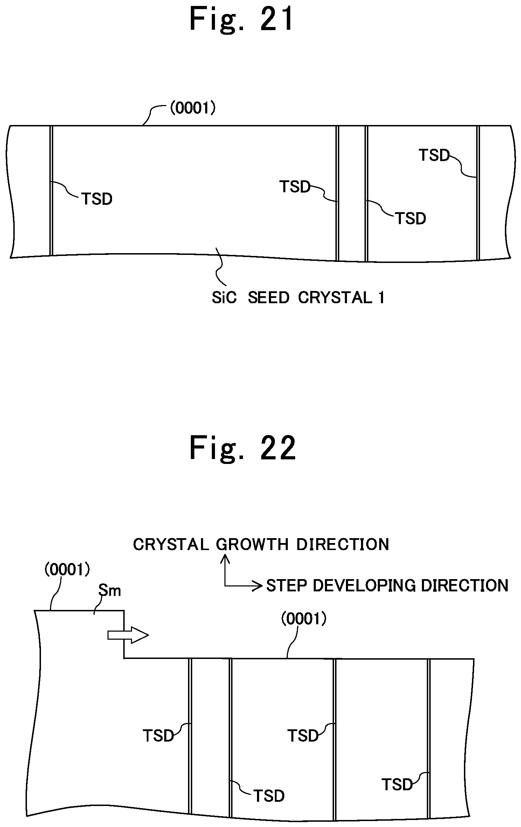

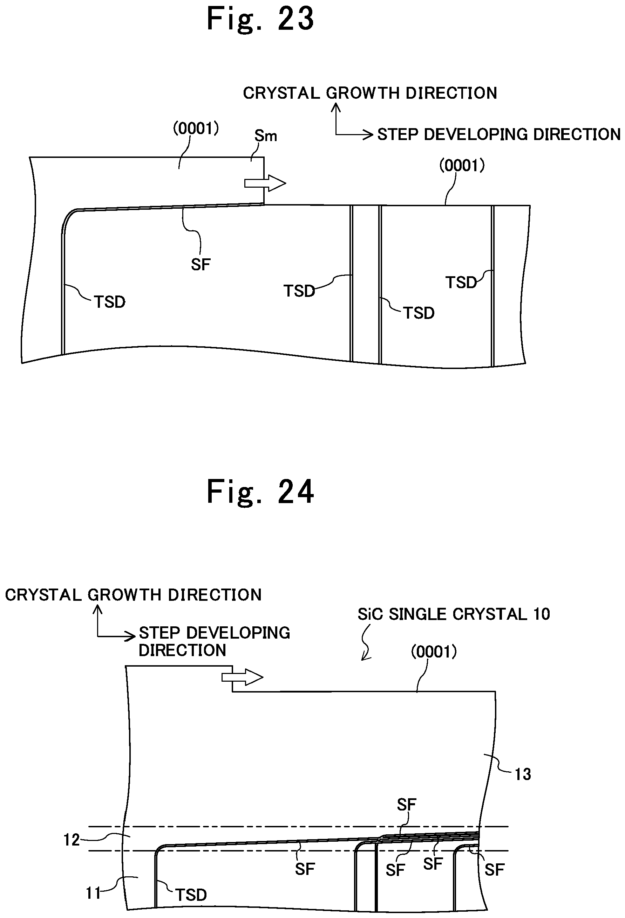

It is thought that threading screw dislocations TSD that extend in a direction substantially perpendicular to the (0001) plane, as illustrated in Fig. 21, are converted into stacking faults SF that extend in a direction substantially parallel to the (0001) plane (that is, the basal plane) by developing the above-described macrosteps $S_m$ as illustrated in Figs. 22 and 23.

As indicated by arrows in Figs. 21 to 23, a direction in which each step S is developed when a SiC single crystal is grown (step developing direction) is a direction substantially parallel to the (0001) plane. On the other hand, the growth direction of the threading screw dislocations TSD is a direction substantially perpendicular to the (0001) plane. That is, the step developing direction and the growth direction of the threading screw dislocations TSD are substantially perpendicular to each other. Therefore, during the crystal growth of the SiC seed crystal 1 having the macrosteps $S_m$, as illustrated in Fig. 22, a crystal is grown while the macrosteps $S_m$ pass through the threading screw dislocations TSD. In this case, as illustrated in Fig. 23, the growth direction of the threading screw dislocations TSD is changed to a direction substantially parallel to the (0001) plane and is converted into a stacking fault SF. The reason why this phenomenon occurs is not clear, but it is thought that the height of the step is associated. That is, the growth direction of the threading screw dislocations TSD and the step developing direction of the SiC single crystal are substantially perpendicular to each other. Therefore, in a case where the heights of the steps formed on the crystal growth surface (0001) are great (that is, when the steps are the macrosteps $S_m$), it is thought that threading screw dislocations TSD are easily bent by an image force and are easily converted into stacking faults SF of the basal plane. In other words, in the SiC single crystal producing method of the present invention, the threading screw dislocations TSD can be converted as long as the macrosteps $S_m$ are formed in the seed crystal 1 and the macrosteps $S_m$ are developed on the threading screw dislocations TSD. In an existing crystal growth method, it is considered that crystal growth may be performed so as not to form steps S having great heights. Therefore, according to the existing crystal growth method, it is thought that only steps S having small heights are formed, macrosteps $S_m$ are not formed, and threading screw dislocations TSD cannot be converted.

Furthermore, as illustrated in Fig. 24, when crystal growth of a SiC single crystal 10 further proceeds after the conversion of the threading screw dislocations TSD into the stacking faults SF, a SiC single crystal 10 having three layers including a layer (first layer 11) which is originated from the seed crystal 1 and has threading screw dislocations TSD, a second layer 12 which is formed continuously from the first layer 11 and has stacking faults SF, and a third layer 13 which is formed continuously from the second layer 12 and has a smaller number of threading screw dislocations TSD than that of the first layer 11 is obtained. This is because the stacking faults SF are the defects of the basal plane and are not continued in the crystal growth direction. The second layer 12 has a smaller number of threading screw dislocations TSD and a larger number of stacking faults SF than those of the first layer 11. Since the third layer 13 is a portion which is grown after the threading screw dislocations TSD are converted into the stacking faults SF, the number of threading screw dislocations TSD therein is significantly reduced compared to that of the first layer 11, and the number of stacking faults SF is also significantly reduced. Therefore, by cutting the third layer 13 from the SiC single crystal 10, the SiC single crystal 10 with a very small number of threading screw dislocations TSD can be obtained. Depending on the purpose of the SiC single crystal 10, there may be cases where it is only required to reduce the number of defects that are formed to penetrate through the SiC single crystal 10 in the crystal growth direction. And in the case, the threading screw dislocations TSD may be present in a portion of the SiC single crystal 10 in the crystal growth direction. In these cases, the SiC single crystal 10 obtained in the above-described producing method may be used as it is.

In a case of producing a SiC single crystal as described above, there is an advantage in that a SiC single crystal with no threading screw dislocation (or the number of threading screw dislocations is very low) can be relatively easily produced within a short time. In addition, when the SiC single crystal with a small number of threading screw dislocations obtained as described above is used as the seed crystal, it is possible to grow a SiC single crystal with a small number of threading screw dislocations using a general liquid phase method or vapor phase method. That is, according to the producing method of the present invention in which step bunching is allowed to proceed on the SiC single crystal, macrosteps can be formed on the crystal growth surface of the SiC single crystal, and furthermore, it is possible to easily produce a SiC single crystal with a small number of threading screw dislocations within a short time.

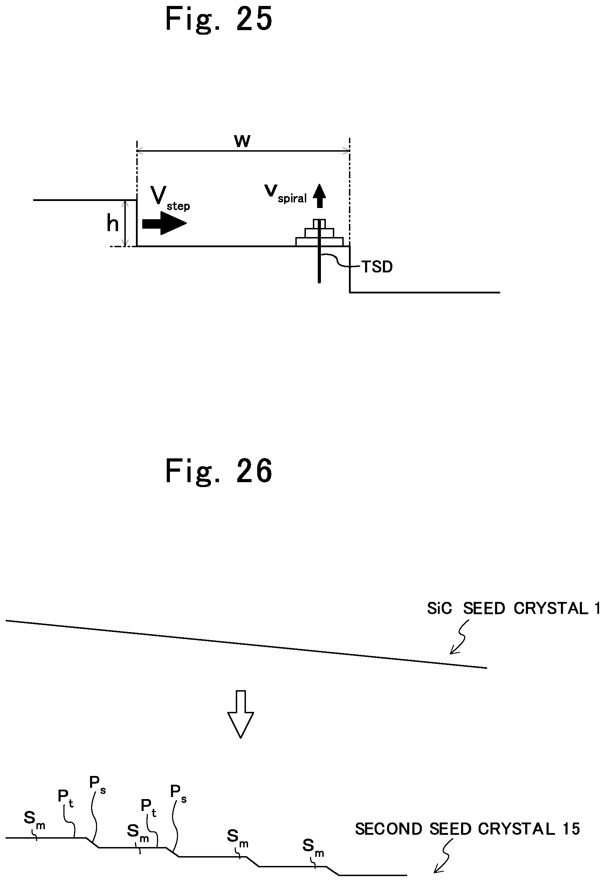

However, as described above, when the growth speed of screw dislocations is faster than the step developing speed, the steps are not developed and screw dislocations remain, resulting in the occurrence of spiral growth. Therefore, as illustrated in Fig. 25, when it is assumed that the height of the macrostep is h, the step developing speed is $V_{step}$, the terrace width is w, and the growth speed of the screw dislocations is $v_{spiral}$, a condition for causing the development of steps is expressed as follow.

$$V_{spiral} < (h \times v_{step})/w$$

In Tests 1 to 3 described above, $V_{spiral}$ was 9 $\mu$m/h, and $v_{step}$ was 500 $\mu$m/h. When these are substituted into the above expression, $0.018 < h/w$ is satisfied. This becomes the condition for causing the development of steps during the crystal growth of the SiC single crystal. In a case of Test 1 (with a minimum value of the step height of 80 nm, an off angle of 1.25°, and a conversion ratio of the threading screw dislocations of 90%), w = 8.5 $\mu$m was satisfied. Therefore, when this is substituted, it can be thought that the condition for causing the development of steps approximates to 70 nm < h. It is thought that in such a range, conversion of the threading screw dislocations due to the macrosteps occurs. That is, when macrosteps having a height of greater than 70 nm are formed in a step forming process, a SiC single crystal in which the number of threading screw dislocations is reduced can be obtained.

An example of a method of forming macrosteps is described as follows. When an off angle with respect to the (0001) plane of the seed crystal 1 is formed as illustrated in Fig. 3, a large number of small steps made of Si atoms and/or C atoms are formed on the surface of the seed crystal 1. In a case crystal growth is performed on the seed crystal provided with the off angle, in general, the crystal growth surface is formed so that the surface energy thereof is reduced. In a case of 4H-SiC, it is thought that since the (0001) plane and a (30-38) surface are stable surfaces with a low surface energy, steps in the atomic unit are bunched so as to expose such surfaces and thus macrosteps $S_m$ are formed. More specifically, it is thought that the (0001) plane is a terrace surface $P_t$ of each step in Fig. 26, and the (30-38) surface is a side surface $P_s$. Therefore, it is thought that when an off angle is formed with respect to the (0001) plane, a SiC single crystal is grown on the (0001) plane $P_s$ and the (30-38) surface $P_t$ as the crystal growth surface, and macrosteps $S_m$ are formed.

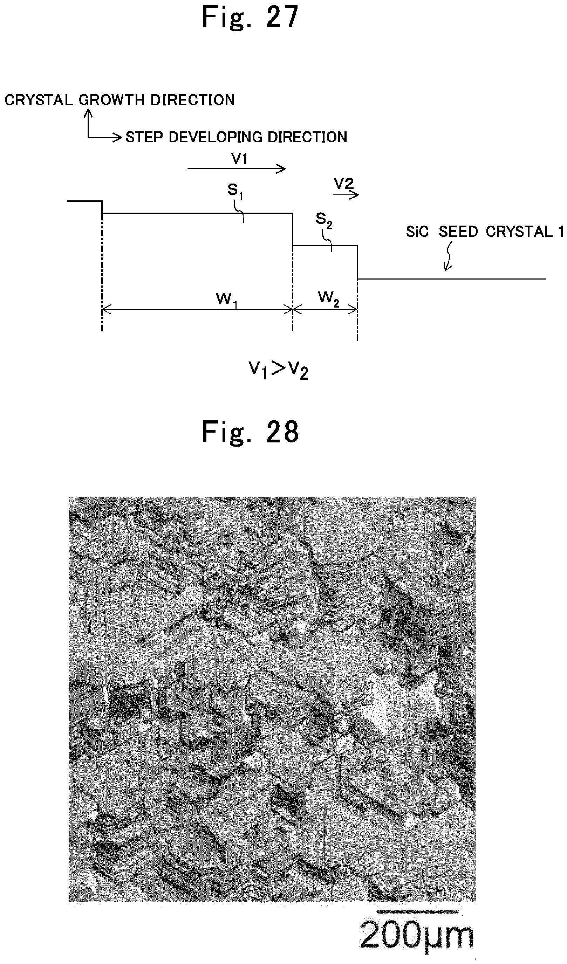

Furthermore, it may be thought that even in steps having a relatively small height, the step height increases as the crystal growth (the development of steps) of the seed crystal 1 proceeds, and thus macrosteps $S_m$ are formed. In a case where Si and C are supplied to the steps from an upper step, the developing speed of the steps increases as the terrace width of the step at the upper step increases. That is, since W1 > W2 is satisfied in Fig. 27, the step developing speed $V_1$ of the upper step (step $S_1$) becomes faster than the step developing speed $V_2$ of a lower step (step $S_2$). In this case, $S_1$ catches up with $S_2$, and $S_1$ and $S_2$ become a single step, resulting in an increase in the step height. That is, in this case, it is thought that bunching proceeds at the lower step (step $S_2$), the step height h increases, and thus macrosteps $S_m$ are formed. A process of forming macrosteps $S_m$ as described above is referred to as a step forming process. In Tests 1 to 3, crystal growth was further performed on the seed crystal 1 (referred to as a second seed crystal 15) where the macrosteps $S_m$ are formed as illustrated in Figs. 22 to 24 to develop the macrosteps on the threading screw dislocations. This process corresponds to a crystal growth process in the SiC single crystal producing method of the present invention.

As the height of the macrostep increases, the conversion ratio of threading screw dislocations into stacking faults increases. Therefore, in consideration of an image force, the height of the macrostep is preferably as great as possible. Specifically, the height of the macrostep is preferably equal to or greater 80 nm, and more preferably equal to or greater than 100 nm. By growing a SiC single crystal using the second seed crystal in which at least one, preferably a plurality of macrosteps are formed, it is possible to obtain a SiC single crystal in which the number of threading screw dislocations is significantly reduced.

[Relationship between Step Height and Step Development]

A micrograph of the SiC single crystal of Test 4 taken by using a Nomarski differential interference contrast microscope (Leica DM4000 M) is illustrated in Fig. 28. As illustrated in Fig. 28, a large number of hillocks (protrusions not in a step shape) generated by spiral growth due to threading screw dislocations were observed on the growth surface of the SiC single crystal of Test 4. From the result, it can be seen that the spiral growth occurs prior to the step development in the SiC single crystal of Test 4, which implies that conversion of the threading screw dislocations had occurred in the SiC single crystal of Test 4 but the degree of the conversion was low. That is, it is thought that although macrosteps were formed in the seed crystal in the producing method of Test 4, the number of macrosteps was smaller than those of Test 1 and the like and the frequency of conversions of the threading screw dislocations was also lower than that of Test 1.

That is, it is thought that in the SiC single crystal producing methods of Tests 1 to 3, a large number of macrosteps which are steps having a height of greater than 70 nm are formed in a macrostep forming process and the macrosteps are developed on a large number of threading screw dislocations, while, in the SiC single crystal producing method of Test 4, most of steps formed in the macrostep forming process are steps having a height of less than 70 nm and the number of steps was relatively small. That is, it can be seen that in a case of forming macrosteps by forming an off angle, the off angle is preferably equal to or greater than 1°.

(Test 5)

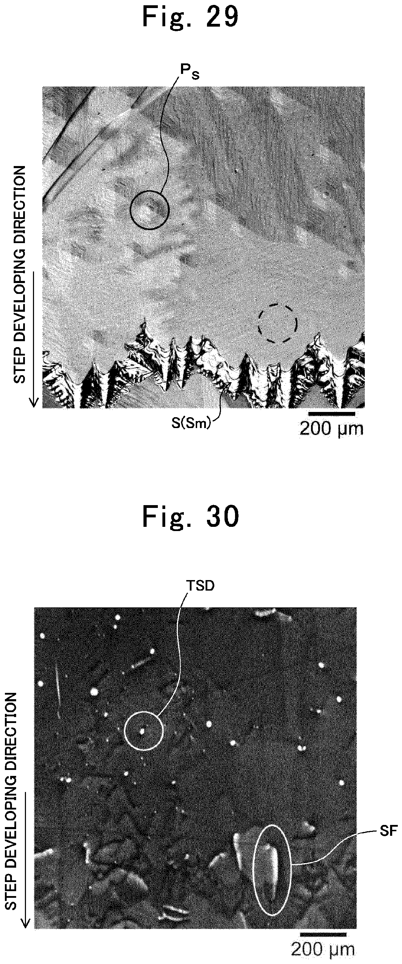

A SiC single crystal of Test 5 was obtained by growing a SiC single crystal in substantially the same method as that of Test 1 except that an off angle is not provided in a seed crystal. A micrograph of the SiC single crystal of Test 5 taken by using a Nomarski differential interference contrast microscope is illustrated in Fig. 29. In addition, an X-ray topograph of the SiC single crystal of Test 5 taken at the same point as that of Fig. 29 is illustrated in Fig. 30.

On the seed crystal in which an off angle is not provided (on-axis seed crystal), spiral growth proceeds from threading screw dislocations as the starting points. In the X-ray topograph of Fig. 30 in which the SiC single crystal of Test 5 is photographed, threading screw dislocations TSD indicated by dot-shaped contrasts are confirmed. In addition, in a surface morphology image of Fig. 29, hexagonal patterns $P_s$ are confirmed as the same positions as those of the threading screw dislocations TSD. The hexagonal patterns $P_s$ indicate that spiral growth had occurred. When the hexagonal patterns $P_s$ are grown, hillocks are formed. The hillocks are grown while extending along the crystal growth surface. Therefore, in a portion of the peripheral edge portion of a hillock, which does not interfere with another hillock, step development occurs. In the lower part of the surface morphology image of Fig. 29, a plurality of steps S which are traces of the step development are seen.

As illustrated in the X-ray topograph of Fig. 30, in the portion where the step development had occurred, line-shaped contrasts that extend in the step developing direction are confirmed. For example, there is a portion surrounded by ellipse in Fig. 30. The line-shaped contrast indicates that the threading screw dislocation TSD is converted into a stacking fault SF. In the surface morphology image of Fig. 29, the hexagonal pattern $P_s$ at the same position as the position where the line-shaped contrast is formed (a position surrounded by broken line in the figure) are not recognized. This also supports the conversion of the threading screw dislocation TSD into the stacking fault SF.

As in the SiC single crystal producing methods of Tests 4 and 5, there may be cases where hillocks caused by the threading screw dislocations are formed and step development caused of the hillocks occurs, resulting in the conversion of the threading screw dislocations (Fig. 28, Fig. 29). However, there may also be cases where even when hillocks caused by the threading screw dislocations are formed, step development does not occur and the threading screw dislocations are not converted. It is thought that the difference between the two is dependent on the continuation of the step development, and it is thought that the cause is dependent on the step height as in the above expression. That is, it is thought that in a case where steps having small step heights are developed, the development of the steps is impeded by some reasons and is not continuously performed. It is thought that in this case, conversion of the threading screw dislocations does not occur. On the other hand, it is thought that in a case where steps having great step heights are developed, the development of the steps proceeds and thus conversion of the threading screw dislocations occurs.

From the result of Test 5, it can be seen that as one of methods of developing macrosteps without providing an off angle in a seed crystal, a method of forming hillocks may be used. It is thought that in a case of developing steps caused by hillocks, the growth speed of a portion of a crystal may be increased by providing a temperature distribution in the growth surface or varying the amount of a C source supplied to the steps. For example, by locally cooling the seed crystal, or by supplying carbon to a portion of the seed crystal prior to the other portions by controlling the convection direction or speed of a SiC solution, the supersaturation degree or supercooling degree of the SiC solution that is present in the vicinity of the seed crystal can be increased. In these cases, as illustrated in Fig. 27, the difference between the step developing speed $V_1$ of the step $S_1$ at the upper step and the step developing speed $V_2$ of the step $S_2$ at the lower step can be increased, and thus the development of macrosteps can be accelerated. That is, when the crystal producing apparatus is used, growth of macrosteps caused by hillocks is also facilitated.

[Suppression of Polymorph]

A SiC single crystal has many crystal polymorphs. Crystal polymorphs refer to crystals which have stoichiometrically the same composition but differ in the stacking sequence of regular tetrahedron structure layers having a regular tetrahedron structure with Si-C bonds. Representative polymorphs include 3C-SiC, 6H-SiC, 4H-SiC, and 15R-SiC. Depending on the usage of the SiC single crystal, there may be cases where it is not preferable than polymorphs are generated. In a case where a SiC single crystal undergoes two-dimensional nucleus growth, it is known that there may be cases where it is difficult for the stacking sequence of regular tetrahedron structure layers to take over the crystal growth direction, that is, a direction perpendicular to the (0001) plane. On the other hand, in a case where crystal growth which accompanies step development as described above occurs or in a case where spiral growth occurs, it is thought that the stacking sequence of regular tetrahedron structure layers takes over the crystal growth direction compared to a case of two-dimensional nucleus growth. In addition, it is known that the spiral growth occurs in the presence of threading screw dislocations.

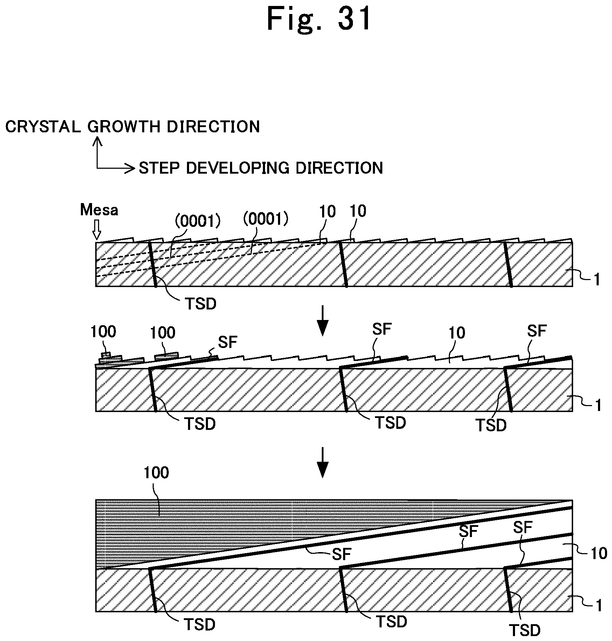

For example, as illustrated in the upper figure of Fig. 31, in a case where a SiC single crystal 10 is grown on a seed crystal 1 provided with an off angle by a liquid phase growth method, first, step development occurs. When crystal growth which accompanies the step development occurs, as described above, the stacking sequence is easily taken over. Therefore, polymorphic variations are less likely to occur. However, a portion to which steps are not supplied (so-called a Mesa portion) from the off angle of the seed crystal 1 is generated in the crystal growth surface of the seed crystal 1. In this portion, as illustrated in the intermediate figure of Fig. 31, two-dimensional nucleus growth occurs. A two-dimensional nucleus growth portion 100 is positioned on the rear side in the step developing direction (that is, the upstream side) and thus easily covers the other portions. In addition, when the two-dimensional nucleus growth occurs, the stacking sequence is less likely to be taken over as described above. Therefore, in this case, as illustrated in the lower figure of Fig. 31, there may be cases where polymorphic variations occur in the two-dimensional nucleus growth portion 100 and the crystal growth surface is covered with polymorphs (that is, the two-dimensional nucleus growth portion 100) different from the other portions. That is, in a case where crystal growth which accompanies step development occurs, there is a possibility that polymorphic variations may occur. It is thought that this is also applied to the case of developing macrosteps as described above.

The inventors of the present invention intensively studied, and as a result, have found that conversion of threading screw dislocations and suppression of the generation of polymorphs can be allowed to compatible with each other by developing macrosteps in a predetermined direction on a portion of the crystal growth surface of a SiC seed crystal when a SiC single crystal is grown on the SiC seed crystal and allowing the SiC single crystal to undergo spiral growth on the other portions of the crystal growth surface of the seed crystal. More specifically, by forming the off angle at only the portion of the SiC seed crystal and developing macrosteps in the predetermined direction, the threading screw dislocations can be converted into stacking faults as described above. On the other hand, an off angle is not formed at the other portions of the SiC seed crystal and polymorphic variations due to two-dimensional nucleus growth are suppressed. In this case, the SiC single crystal primarily undergoes spiral growth derived from the threading screw dislocations included in the SiC seed crystal. The stacking sequence of the SiC seed crystal is taken over by the SiC single crystal as the spiral growth proceeds. Therefore, in this case, it is possible to obtain a SiC single crystal having the same stacking sequence as that of the SiC seed crystal. In addition, in the portion where the macrosteps are developed as described above, a SiC single crystal with a small number of threading screw dislocations is obtained. Therefore, for example, when this portion is cut, a SiC single crystal in which the generation of polymorphs is suppressed and the number of threading screw dislocations is small can be obtained. In this manner, a SiC single crystal in which the generation of polymorphs is suppressed and the number of threading screw dislocations is small can be obtained. Hereinafter, a specific example is described.

(Test 6)

Test 6 uses the same method as that of Test 1 except that an off angle is provided at only a portion of a seed crystal and an off angle is not formed at the other portions of the SiC seed crystal.

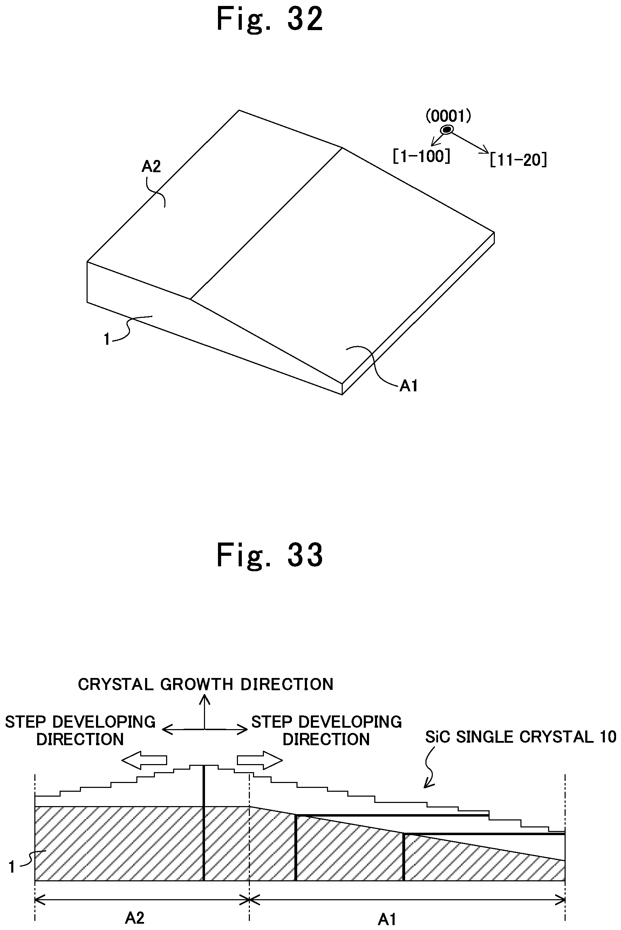

Specifically, as illustrated in Fig. 32, an off angle is formed at a portion (a first region A1) of the crystal growth surface of a SiC seed crystal and an off angle is not formed at the other region (a second region A2). That is, the second region A2 is a (0001) on-axis surface. The off angle provided at the first region was 2°, and a direction in which the off angle is provided (that is, a step developing direction) was a [11-20] direction. In Test 6, the crystal growth time was 5 hours. The first region A1 was disposed closer to the leading side of the step developing direction (that is, the downstream side) than the second region A2. Therefore, as illustrated in Fig. 33, crystal growth which accompanied the development of macrosteps had occurred on the first region A1. On the other hand, the SiC single crystal had undergone spiral growth on the second region A2. According to the SiC single crystal producing method of Test 6, a SiC single crystal of Test 6 was obtained.

The polymorph structure of the SiC single crystal of Test 6 was evaluated by using Raman spectroscopy. In addition, the defect density of the SiC single crystal of Test 6 was evaluated through molten KOH etching.

In a case of using a seed crystal in which an off angle is provided at the entire crystal growth surface, the surface of the seed crystal is covered with a SiC single crystal that is grown through two-dimensional nucleation as crystal growth proceeds. Therefore, it is difficult to maintain the stacking sequence of regular tetrahedron structure layers as described above (that is, to suppress the generation of SiC polymorphs). However, as illustrated in Figs. 32 and 33, in Test 6, the seed crystal in which the first region A1 provided with the off angle with respect to the (0001) plane and the second region A2 formed as the (0001) on-axis surface are combined is used. Therefore, steps formed by the spiral growth in the second region A2 are continuously supplied to the first region. Therefore, in the SiC single crystal producing method of Test 6, two-dimensional nucleation is less likely to occur. Accordingly, regarding the SiC single crystal of Test 6, in the portion formed on the first region A1 of the seed crystal, polymorphic variations did not occur.

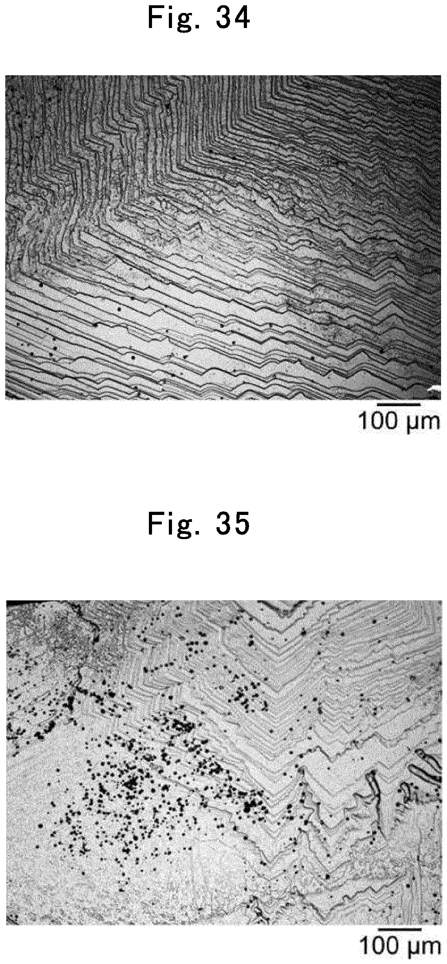

Figs. 34 and 35 illustrate crystal surfaces after the molten KOH etching. Fig. 34 illustrates the crystal surface formed on the first region A1 of the seed crystal, and Fig. 35 illustrates the crystal surface formed on the second region A2 of the seed crystal. A location where dislocations are present is first etched and thus dents (etch pits) are generated. As illustrated in Fig. 35, in the second region A2, a large number of large etch pits which represent the presence of threading screw dislocations and a large number of etch pits which represent the presence of threading edge dislocations and basal plane dislocations were observed. The etch pit density in the second region A2 was $2 \times 10^5$ etch pits/cm$^2$, and the density of the threading screw dislocations thereof was $3 \times 10^3$ dislocations/cm$^2$.

On the other hand, as illustrated in Fig. 34, on the first region A1, that is, on the crystal surface formed on the portion provided with the off angle in the seed crystal, large etch pits that represent the presence of threading screw dislocations were rarely present, and the etch pit density was low. The etch pit density in the first region A1 was $8 \times 10^4$ etch pits/cm$^2$, and the density of the threading screw dislocations thereof was $1 \times 10^2$ dislocations/cm$^2$ or less.

As described above, the SiC single crystal is grown by providing the first region and the second region in the seed crystal, and thus suppression of polymorphs caused by spiral growth and conversion of threading screw dislocations caused by developing steps on the threading screw dislocations are compatible with each other. That is, in this case, it can be seen that the etch pit density and the number of threading screw dislocations can be reduced while suppressing polymorphs.

[Reduction in Threading Edge Dislocations]

For a further improvement in the quality of the SiC single crystal, a technique of reducing the number of threading edge dislocations, which are defects other than the above-described threading screw dislocations, is desired. As a SiC seed crystal for producing a SiC single crystal in which the number of threading edge dislocations is reduced, 4H-SiC or 6H-SiC which is a hexagonal crystal may be used. In addition, it is thought that a SiC single crystal having a small number of edge dislocations is obtained by developing steps made of SiC in a predetermined direction on the crystal growth surface of a SiC seed crystal. That is, the inventors of the present invention intensively studied, and as a result, have found that, when a SiC single crystal is grown, a threading edge dislocation can be converted into a basal plane dislocation by developing steps in the same direction as or an opposite direction to the Burgers vector of the threading edge dislocation. The reason is not clear but is thought as follow.

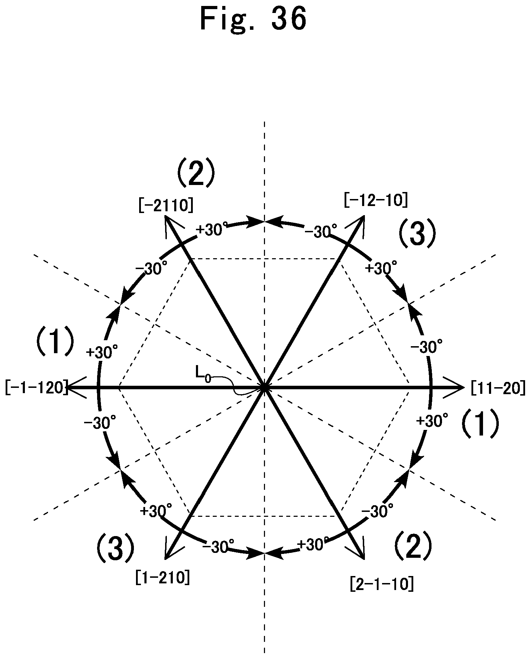

A SiC seed crystal also has threading edge dislocations (TED) in addition to the above-described threading screw dislocations (TSD). The threading edge dislocations TED extend in a direction substantially perpendicular to the (0001) plane like the threading screw dislocations (TSD) illustrated in Fig. 21 and the like. In the SiC single crystal producing method of the present invention, 4H-SiC or 6H-SiC which is a hexagonal crystal is used as the SiC seed crystal. Therefore, the Burgers vector of the threading edge dislocation (TED) formed in the 4H-SiC or 6H-SiC is any of $1/3 < 11\text{-}20 >$, that is, $1/3[\text{-}1\text{-}120]$, $1/3[11\text{-}20]$, $1/3[\text{-}2110]$, $1/3[21\text{-}10]$, $1/3[1\text{-}210]$, or $1/3[\text{-}1210]$ illustrated in Fig. 36.

The inventors of the present invention allowed steps to be developed on the crystal growth surface of the SiC seed crystal, that is, the (0001) plane and allowed the step developing direction to be the same direction as or the opposite direction to the Burgers vector of the threading edge dislocation, as in the conversion of the threading screw dislocations described above. By allowing the steps to be developed on the threading edge dislocation in the above directions, the threading edge dislocation TED included in the SiC seed crystal could be converted into a basal plane dislocation BPD that extends in a direction substantially parallel to the (0001) plane (that is, the basal plane). The reason why this phenomenon occurs is not clear, but it is thought that the height of the step is associated. That is, the growth direction of the threading edge dislocation TED is substantially perpendicular to the step developing direction of the SiC single crystal. Therefore, it is thought that in a case where the heights of the steps formed on the crystal growth surface (0001) on which the steps are developed are great (that is, when the steps are macrosteps $S_m$), a threading edge dislocation TED having a Burgers vector in the same direction as or an opposite direction to the step developing direction is easily bent by an image force and is easily converted into a basal plane dislocation BPD.

However, in the threading edge dislocation that extends in a direction substantially perpendicular to the (0001) plane, the direction of the Burgers vector thereof is a direction perpendicular to the dislocation line. Therefore, the Burgers vector of the threading edge dislocation is one direction selected from various directions depending on the crystal structure of the seed crystal. In other words, the threading edge dislocation (TED) formed in 4H-SiC or 6H-SiC is directed in the Burgers vector of any of six directions including a [-1-120] direction, a [11-20] direction, a [-2110] direction, a [21-10] direction, a [1-210] direction, and a [-1210] direction as illustrated in Fig. 36. Here, the [-1-120] direction and the [11-20] direction are directions opposite to each other. In addition, the [-2110] direction and the [21-10] direction are directions opposite to each other. Furthermore, the [1-210] direction and the [-1210] direction are directions opposite to each other. Therefore, the above-mentioned six directions are practically classified into three pairs including (I) the [-1-120] direction or the [11-20] direction, (II) the [-2110] direction or the [21-10] direction, and (III) the [1-210] direction or the [-1210] direction. Therefore, the Burgers vector of the threading edge dislocation (TED) formed in 4H-SiC or 6H-SiC is coincident with any of the above-mentioned (I) to (III) directions. In addition, by developing the steps in any of the (I) to (III) directions, the threading edge dislocation that is present in the seed crystal can be converted into a basal plane dislocation, and furthermore, a SiC single crystal with no threading edge dislocation or a SiC single crystal in which threading edge dislocations are present only in a portion thereof can be obtained.

Furthermore, as a result of intensive study by the inventors of the present invention, it has been found that conversion of the threading edge dislocation into the basal plane dislocation occurs even in a case where the step developing direction is not completely coincident with the (I) to (III) directions. Specifically, when the step developing direction is in an angle range of about ±30° from the Burgers vector of any of the directions, conversion of the threading edge dislocation occurs as in the case where the steps are developed in the same direction as or the opposite direction to each Burgers vector and are allowed to pass through the threading edge dislocations.

That is, as illustrated in Fig. 36, an arbitrary normal line $L_0$ with respect to the (0001) plane of the SiC seed crystal is selected, and the six Burgers vectors with respect to the normal line $L_0$ are selected. In addition, the steps are developed in a direction in which the crossing angle with respect to each Burgers vector is -30° or less and less than +30°. Specifically, (1) when steps are developed in a direction in which the crossing angle with respect to the [-1-120] direction is -30° or less and less than +30° or in a direction in which the crossing angle with respect to the [11-20] direction is -30° or less and less than +30°, a threading edge dislocation of which the Burgers vector is the [-1-120] direction and a threading edge dislocation of which the Burgers vector is the [11-20] direction can be converted. In addition, (2) when steps are developed in a direction in which the crossing angle with respect to the [-2110] direction is - 30° or less and less than +30° or in a direction in which the crossing angle with respect to the [21-10] direction is -30° or less and less than +30°, a threading edge dislocation of which the Burgers vector is the [-2110] direction and a threading edge dislocation of which the Burgers vector is the [21-10] direction can be converted. In addition, (3) when steps are developed in a direction in which the crossing angle with respect to the [-1210] direction is -30° or less and less than +30° or in a direction in which the crossing angle with respect to the [1-210] direction is -30° or less and less than +30°, a threading edge dislocation of which the Burgers vector is the [-1210] direction and a threading edge dislocation of which the Burgers vector is the [1-210] direction can be converted.

In addition, +30° and -30° mentioned here indicate angles of the (0001) plane about the normal line $L_0$ with respect to the (0001) plane. More specifically, an arc direction from [-1-120] to [-2110] (a clockwise direction in Fig. 36) is referred to as a + direction, and a direction opposite thereto (an arc direction from [-2110] to the [-1-120] direction; a counterclockwise direction in Fig. 36) is referred to as a - direction. Therefore, (1) to (3) described above can be rephrased as follows.

(1) is a direction at less than 30° toward the [-2110] direction or at 30° or less toward the [1-210] direction with respect to the [-1-120] direction, or a direction at less than 30° toward the [21-10] direction or at 30° or less toward the [-1210] direction with respect to the [11-20] direction.

(2) is a direction at less than 30° toward the [-1210] direction or at 30° or less toward the [-1-210] direction with respect to the [-2110] direction, or a direction at less than 30° toward the [1-210] direction or at 30° or less toward the [11-20] direction with respect to the [21-10] direction.

(3) is a direction at less than 30° toward the [11-20] direction or at 30° or less toward the [-2110] direction with respect to the [-1210] direction, or a direction at less than 30° toward the [-1-120] direction or at 30° or less toward the [21-10] direction with respect to the [1-210] direction.

As a matter of course, in order to increase a frequency at which the threading edge dislocations are converted, it is preferable that the steps be developed in two or more directions of (1) to (3). Specifically, it is preferable that the steps be developed in two directions among (1) to (3), and it is more preferable that the steps be developed in all of the three directions. That is, it is preferable that the crystal growth process in which the steps are developed as the crystal growth of the SiC single crystal proceeds be repeated two or more times in two or more different directions. Otherwise, in order to increase a frequency at which the threading edge dislocations are converted, it is more preferable that the step developing direction be a direction close to the Burgers vector of the threading edge dislocation described above. Specifically, it is more preferable that the ranges of the step developing directions of (1) to (3) described above be narrowed as follows: (1) a direction at ±15° or less with respect to the [-1-120] direction or a direction at ±15° or less with respect to the [11-20] direction; (2) a direction at ±15° or less with respect to the [-2110] direction or a direction at ±15° or less with respect to the [21-10] direction; and (3) a direction at ±15° or less with respect to the [-1210] direction or a direction at ±15° or less with respect to the [1-210] direction.

However, even in this case, the direction in which each step is developed when the SiC single crystal is grown (the step developing direction) is a direction substantially parallel to the (0001) plane. On the other hand, the growth direction of the threading edge dislocation TED is a direction substantially perpendicular to the (0001) plane. That is, the step developing direction and the growth direction of the threading edge dislocation TED are substantially perpendicular to each other. Therefore, during the crystal growth of the SiC seed crystal, the crystal growth proceeds while the steps pass through the threading edge dislocation TED. In this case, as in the conversion of the threading screw dislocation TSD illustrated in Fig. 23, the growth direction of the threading edge dislocation TED is changed to a direction substantially parallel to the (0001) plane and the threading edge dislocation TED is converted into a basal plane dislocation BPD. In addition, after the conversion of the threading edge dislocation TED into the basal plane dislocation BPD occurs, SiC crystal growth is further performed. The basal plane dislocation BPD is a defect of the basal plane and is not taken over in the crystal growth direction. A SiC single crystal obtained in this manner includes three layers including a layer (first layer) which is derived from the seed crystal and includes the threading edge dislocation TED, a second layer which is formed continuously from the first layer and includes the basal plane dislocation BPD, and a third layer which is formed continuously from the second layer and includes a smaller number of threading edge dislocations TED than that of the first layer. As in the case of converting the above-described threading screw dislocations TSD, the second layer has a smaller number of threading edge dislocations TED and a larger number of basal plane dislocations BPD than those of the first layer. Since the third layer is a portion which is grown after the threading edge dislocations TED are converted into the basal plane dislocations BPD, the number of threading edge dislocations TED therein is significantly reduced compared to that of the first layer and the number of basal plane dislocations BPD is also significantly reduced. Therefore, by cutting the third layer from the SiC single crystal, a SiC single crystal with a very small number of threading edge dislocations TED can be obtained. Depending on the purpose of the SiC single crystal, there may be cases where it is only required to reduce the number of defects that are formed to penetrate through the SiC single crystal in the crystal growth direction. And in the case, the threading screw dislocations TED may be present in a portion of the SiC single crystal in the crystal growth direction. In these cases, the SiC single crystal obtained in the producing method of the present invention may be used as it is.

In order to increase the frequency of this phenomenon, it is thought that forming steps having great step heights is effective as in the case of converting the threading screw dislocations TSD. That is, when a SiC single crystal is grown on a SiC seed crystal, threading edge dislocations can be converted as long as steps are developed in at least one direction selected from (1) to (3) described above. However, in order to increase the frequency of the conversion, forming macrosteps having great step heights and developing the macrosteps is effective. For reference, in an existing crystal growth method, it is considered that crystal growth may be performed so as not to form steps having great heights. Therefore, according to the existing crystal growth method, it is thought that only steps having small heights are formed, macrosteps are not formed, and threading edge dislocations cannot be converted at a high frequency.

(Test 7)

A SiC single crystal producing method of Test 7 is the same as the SiC single crystal producing method of Test 1 except that setting temperature of the heating element 22 is 1630°C, and the step developing direction is different. As a crystal producing apparatus, the crystal producing apparatus, which is the same as that used in the first embodiment, was used. In Test 7, as a seed crystal, 4H-SiC single crystal (10 mm × 10 mm × 0.35 mm thick) produced by a vapor phase growth method (sublimation method) was used. For reference, a general 4H-SiC single crystal produced by the vapor phase growth method contains threading edge dislocation at a degree of about $10^4$ cm$^{-2}$. The seed crystal used in this test also contained threading edge dislocation at a degree of about $10^4$ cm$^{-2}$. An offset surface directed in the [11-20] direction was formed on the crystal growth surface of the seed crystal, that is, the (0001) plane by cutting. The off angle at this time was 2°. In addition, by using the seed crystal in which the off angle is formed, a SiC single crystal was grown in the same manner as in Test 1.

After 1 hour from the start of the growth (that is, after the start of the contact between the seed crystal and a raw material solution), the seed crystal from which a crystal was grown (that is, a SiC single crystal) was pulled from the raw material solution, and the raw material solution that remained on the surface was removed by an etching treatment. By the above process, the SiC single crystal of Test 7 was obtained. In addition, as described above, in Test 7, the offset surface directed in the [11-20] direction was formed on the crystal growth surface of the seed crystal 1, that is, the (0001) plane by cutting. Therefore, the steps of the SiC single crystal formed on the seed crystal were developed in the [11-20] direction.

(Evaluation)

By using an X-ray topography method using synchrotron radiation X-rays, the SiC single crystal of Test 7 was observed, and defects that had remained in each SiC single crystal were evaluated. In addition, evaluation of defects on the seed crystal before the crystal growth was performed in the same method. In the X-ray topography method, Photon factory BL-15C was used as a beam line. The wavelength was 0.150 nm, and the reflection surface was (11-28).

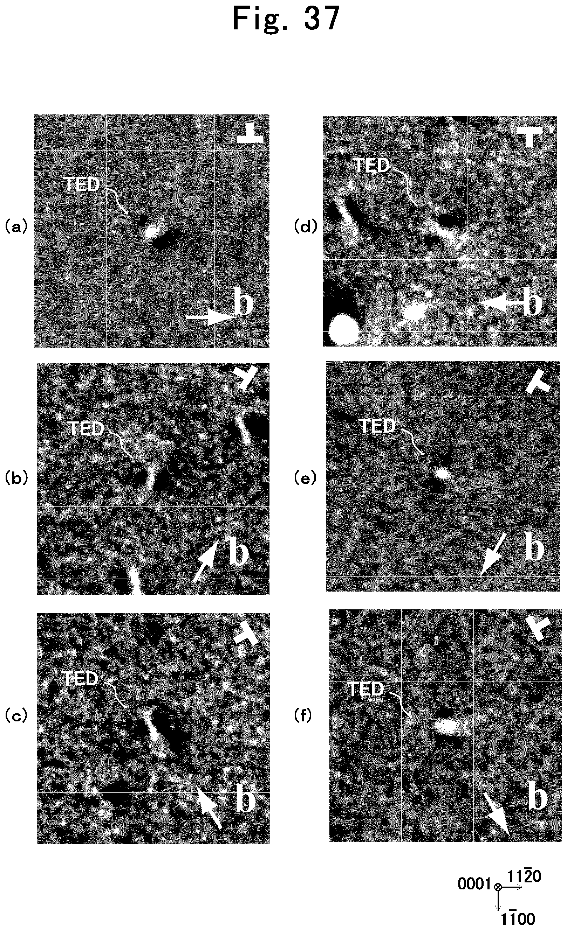

Figs. 37(a) to 37(f) are X-ray topographs of the surface of the seed crystal. As illustrated in Figs. 37(a) to 37(f), six types of threading edge dislocations TED having different Burgers vectors are present in the seed crystal. Here, arrow b in the figure represents the direction of the Burgers vector in each of the threading edge dislocations TED. Specifically, in the threading edge dislocation TED photographed as Fig. 37(a), the Burgers vector is directed in the [11-20] direction. In the threading edge dislocation TED photographed as Fig. 37(b), the Burgers vector is directed in the [-1210] direction. In the threading edge dislocation TED photographed as Fig. 37(c), the Burgers vector is directed in the [-2110] direction. In the threading edge dislocation TED photographed as Fig. 37(d), the Burgers vector is directed in the [-1-120] direction. In the threading edge dislocation TED photographed as Fig. 37(e), the Burgers vector is directed in the [1-210] direction. In the threading edge dislocation TED photographed as Fig. 37(f), the Burgers vector is directed in the [21-10] direction.

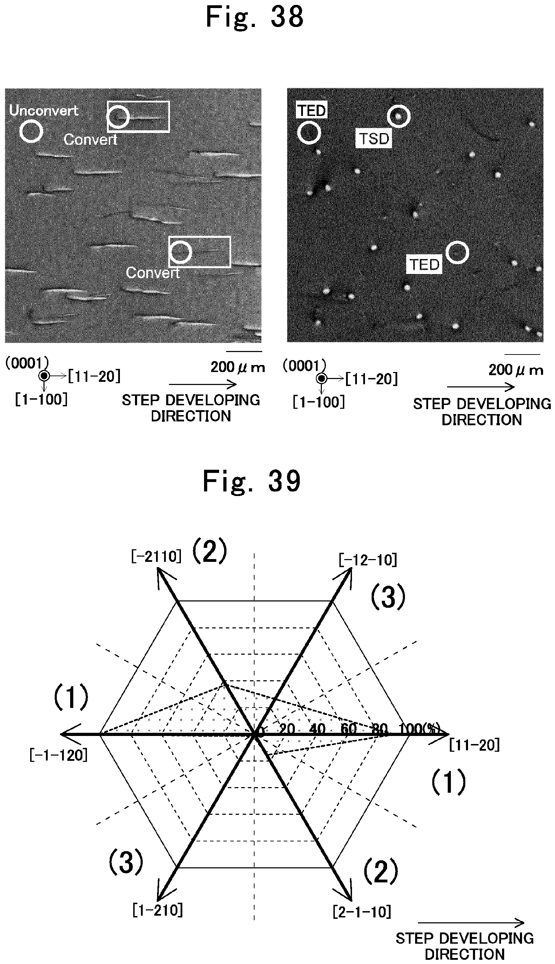

Fig. 38 is an X-ray topograph of the seed crystal and the SiC single crystal at an initial stage of the crystal growth according to the method of Test 7, which were taken at the same point. More specifically, the image illustrated on the right of Fig. 38 is an X-ray topograph of the seed crystal, and the image illustrated on the left of Fig. 38 is an X-ray topograph of the seed crystal of Test 1 at the initial stage of the crystal growth. In the seed crystal before the growth, there were a large number of threading edge dislocations indicated by dot-shaped contrasts. A fair number of threading edge dislocations TED were converted into line-shaped contrasts that extend in the step developing direction in the crystal after the growth. From the result of TEM observation, it was apparent that the defects indicated by such contrasts were basal plane dislocations. From the result, it can be seen that, in the producing method of Test 7, the threading edge dislocations that are present in the seed crystal can be converted into the basal plane dislocations.
Furthermore, the conversion ratio of threading edge dislocations was calculated with each of the directions of the Burgers vectors. Specifically, an arbitrary number of (in this embodiment, 200 to 300) threading edge dislocations that were present in the SiC seed crystal was counted. The Burgers vector of each of the counted threading edge dislocations was visually examined. In addition, it was examined whether or not each of the counted threading edge dislocations was converted into a basal plane dislocation in the seed crystal of Test 7 obtained after the crystal growth process. With each of the Burgers vectors of the threading edge dislocations, the ratio (% by number) of the converted threading edge dislocations was calculated with respect to the number of threading edge dislocations that were present in the seed crystal as 100%. The results are illustrated in Fig. 39.
As illustrated in Fig. 39, in the SiC single crystal of Test 7 obtained by using 4H-SiC as the seed crystal and developing steps in the [11-20] direction when the SiC single crystal is grown on the seed crystal, most of the threading edge dislocations of which the Burgers vector was directed in the [11-20] direction or the [-1-120] direction were converted into basal plane dislocations. More specifically, about 90% of the threading edge dislocations of which the Burgers vector was directed in the [11-20] direction were converted into basal plane dislocations, and the total number of the threading edge dislocations of which the Burgers vector was directed in the [-1-120] direction were converted into basal plane dislocations. From the result, it can be seen that by developing steps in the same direction as or the opposite direction to the Burgers vector of the threading edge dislocations that are present in the SiC seed crystal, the threading edge dislocations can be converted into basal plane dislocations at a high frequency.

In addition, a portion of the threading edge dislocations of which the Burgers vector was directed in the other directions than the [11-20] direction and the [-1-120] direction was remained as the threading edge dislocations, and the other portions were converted into basal plane dislocations. More specifically, about 40% by number of the threading edge dislocations of which the Burgers vector was directed in the [-2110] direction were converted, and about 20% by number of the threading edge dislocations of which the Burgers vector was directed in the [21-10] direction were converted. In addition, about 30% by number of the threading edge dislocations of which the Burgers vector was directed in the [-1210] direction were converted, and about 5% by number of the threading edge dislocations of which the Burgers vector was directed in the [1-210] direction were converted. From the result, it can be seen that the step developing direction and the Burgers vector of the threading edge dislocation may not necessarily be the same direction (or may not be necessarily be the opposite directions to each other). That is, in a case of using 4H-SiC or 6H-SiC as the seed crystal, as long as steps are developed in any of (1) to (3) directions, at least a portion of the threading edge dislocations can be converted into basal plane dislocations and thus a SiC single crystal having a small number of threading edge dislocations can be obtained.

[Relationship between Step Height and Conversion of Threading Dislocations]

A SiC single crystal was grown while forming steps with various heights on the crystal growth of a SiC seed crystal. In addition, the relationship between the step heights and the conversion ratio of threading screw dislocations, and the relationship between the step heights and the conversion ratio of threading edge dislocations were examined. Hereinafter, the threading screw dislocations and the threading edge dislocations are collectively referred to as threading dislocations.

(Test 8)

A SiC single crystal producing method of Test 8 is substantially the same method as the SiC single crystal producing method of Test 3. Specifically, in Test 8, an off angle of 4° was formed at the Si surface of the SiC seed crystal. In addition, crystal growth was performed on the seed crystal in a SiC solution using Si as the Si source. In addition, steps were developed in the [11-20] direction at this time.

(Test 9)

A SiC single crystal producing method of Test 9 is substantially the same method as the SiC single crystal producing method of Test 8 except that an off angle of 4° was formed at the C surface of the SiC seed crystal.

(Test 10)

A SiC single crystal producing method of Test 10 is substantially the same method as the SiC single crystal producing method of Test 8 except that an off angle of 4° was formed at the C surface of the SiC seed crystal and crystal growth was performed on the seed crystal in a SiC solution using a Si-Al alloy as the Si source. The Si-Al alloy used in Test 10 contains 5% of Al with respect to the entire alloy as 100% by mass.

[Evaluation]

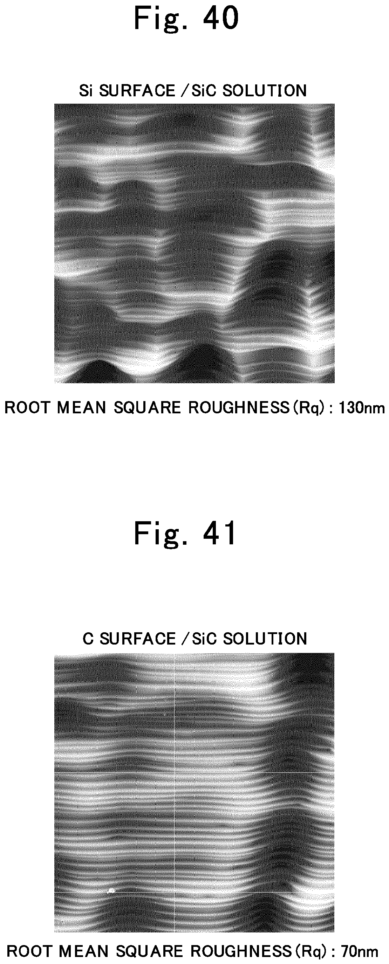

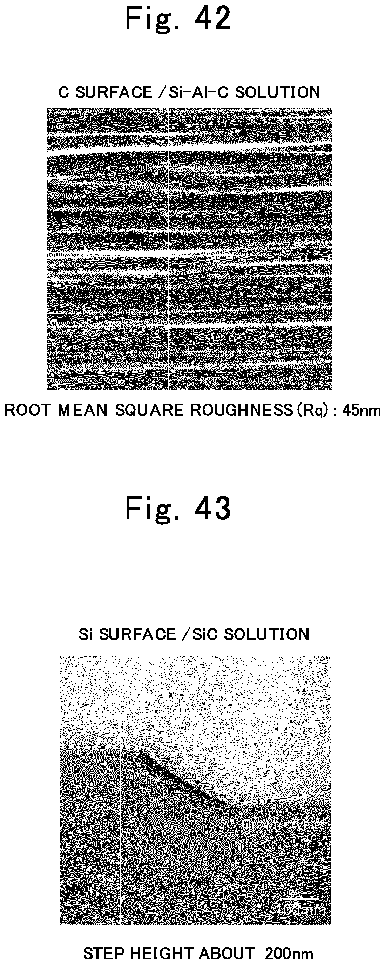

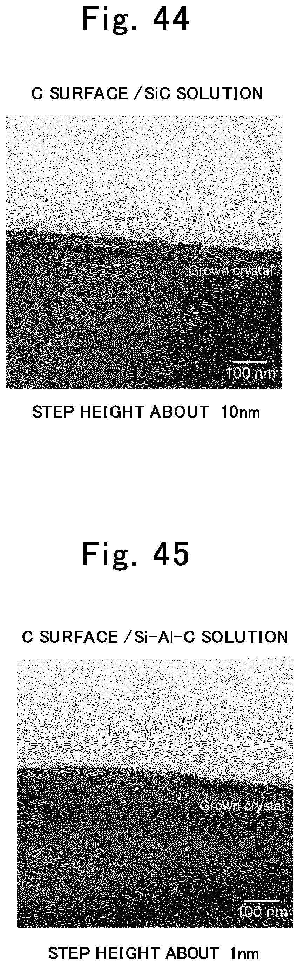

The heights of the macrosteps in the SiC single crystals obtained in Tests 8 to 10 were measured by using a confocal laser scanning microscope and a laser cross-sectional transmission electron microscope. Laser scanning micrographs of the SiC single crystals of Tests 8 to 10 are illustrated in Figs. 40 to 42. In addition, cross-sectional transmission electron micrographs of the SiC single crystals of Tests 8 to 10 are illustrated in Figs. 43 to 45.

As illustrated in Figs. 40 to 42, in the SiC single crystals of Tests 8 to 10, a large number of step bunchings are arrayed in a streaked pattern. Therefore, it can be seen that the steps are developed even in the SiC single crystals of Tests 8 to 10. In addition, it can also be seen from the electron micrographs of Figs. 43 to 45 that the heights of the steps in the SiC single crystals are in the order of Test 8 > Test 9 > Test 10.

Specifically, the heights of the steps in the SiC single crystal of Test 8 were about 200 nm at the maximum and macrosteps were formed on the SiC single crystal of Test 8. In addition, the heights of the steps in the SiC single crystal of Test 9 were about 10 nm at the maximum and macrosteps were not formed on the SiC single crystal of Test 9. Moreover, the heights of the steps in the SiC single crystal of Test 10 were about 1 nm at the maximum and macrosteps were also not formed on the SiC single crystal of Test 10.

In addition, it is thought that the C surface is flatter than the Si surface in the SiC seed crystal. Therefore, it is thought that it was more difficult to form macrosteps having great step heights on the C surface which was relatively flat than the Si surface. In addition, it is thought that by adding Al to a solvent (that is, Si) for dissolving C as a solute, the crystal growth surface of the SiC single crystal was flattened in the atomic level and as a result, only steps having very small step heights were formed on the SiC single crystal of Test 10.

By using an X-ray topography method using synchrotron radiation X-rays, the SiC single crystals of Tests 8 to 10 were observed, and defects that had remained in each SiC single crystal were evaluated. As the X-ray topography method, the same method as the test method described above was used. Evaluation of defects on the seed crystal before the crystal growth was performed in the same method.

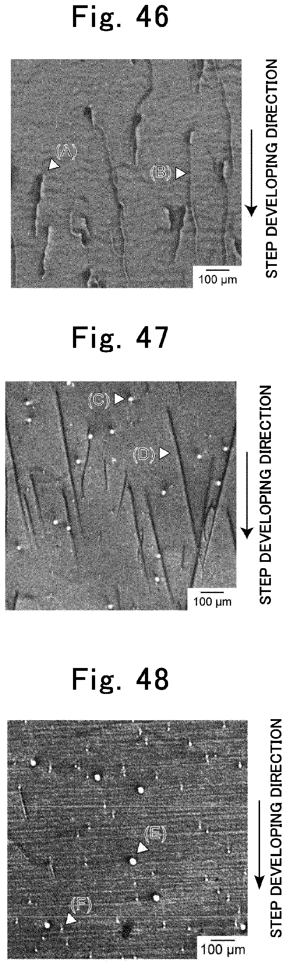

Fig. 46 is an X-ray topograph of the SiC single crystal of Test 8. Fig. 47 is an X-ray topograph of the SiC single crystal of Test 9. Fig. 48 is an X-ray topograph of the SiC single crystal of Test 10. As illustrated in Fig. 46, threading edge dislocations TED were rarely present in the SiC single crystal of Test 8 and the number of threading screw dislocations TSD was small. In addition, a large number of stacking faults SF converted from TSD and basal plane dislocations BPD converted from TED were confirmed. In addition, as illustrated in Fig. 47, in the SiC single crystal of Test 9, the number of threading edge dislocations TED was small, but a large number of threading screw dislocations TSD had remained. In addition, although a relatively large number of basal plane dislocations BPS converted from TED were confirmed, stacking faults SF converted from TSD were not confirmed. Moreover, as illustrated in Fig. 48, in the SiC single crystal of Test 10, both the threading edge dislocations TED and the threading screw dislocations TSD had largely remained. In addition, basal plane dislocations BPS converted from TED were slightly confirmed, and stacking faults SF converted from TSD were not confirmed. The conversion ratios of TED and TSD are shown in Table 1 as follows.

[Table 1]

| | Conversion ratios (%) | | Maximum of the step height | Surface roughness (Rq) |
|---|---|---|---|---|
| | TSD | TED | | |
| Test 8 | 99 | 31 | 200 | 130 |
| Test 9 | 0 | 49 | 10 | 70 |
| Test 10 | 0 | 5 | 1 | 45 |

As shown in Table 1, the step height is closely associated with both the conversion of threading screw dislocations and the conversion of threading edge dislocations. In addition, it can be seen that in order to cause the conversion of threading edge dislocations, the step height is preferably greater than 1 nm, the step height is more preferably equal to or greater than 10 nm, and the step height is even more preferably equal to or greater than 200 nm. In addition, it can be seen that in order to cause the conversion of threading screw dislocations, the step height is preferably greater than 10 nm, and the step height is more preferably equal to or greater than 200 nm.

In addition, the surface roughness (root mean square roughness, Rq) of the crystal growth surface in the SiC single crystal of Test 8 was 130 nm, the surface roughness (Rq) of the crystal growth surface in the SiC single crystal of Test 9 was 70 nm, and the surface roughness (Rq) of the crystal growth surface in the SiC single crystal of Test 10 was 45 nm. In consideration of the result, it can be said that in order to cause the conversion of threading edge dislocations, the surface roughness (Rq) of the crystal growth surface is preferably greater than 45, is more preferably equal to or greater than 70, and even more preferably equal to or greater than 130. In addition, it can be said that in order to cause the conversion of threading screw dislocations, the surface roughness (Rq) of the crystal growth surface is preferably greater than 70, and is more preferably equal to or greater than 130.

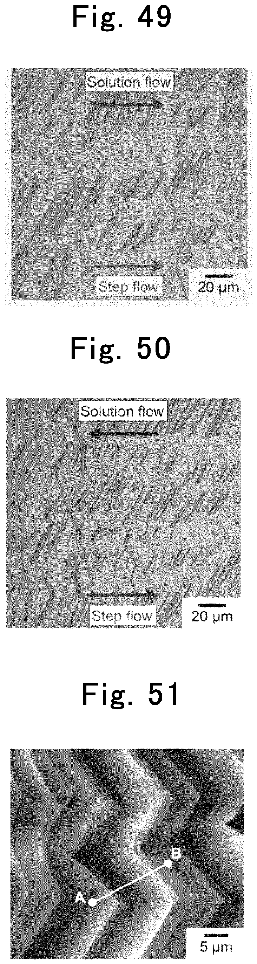

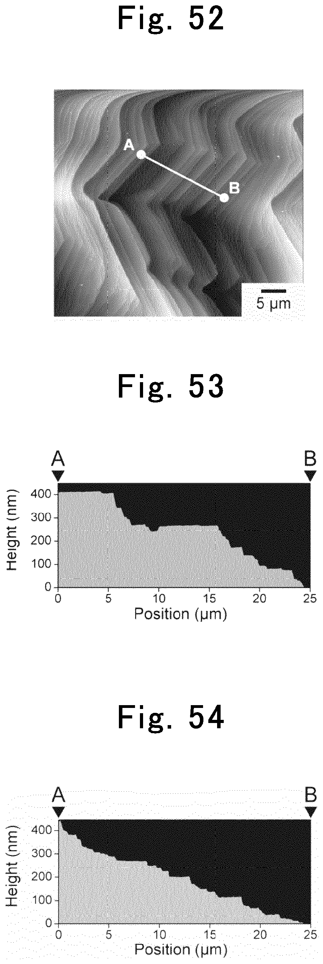

Regarding the SiC single crystal 1a produced in the first embodiment, a micrograph taken by a Nomarski differential interference contrast microscope is illustrated in Fig. 49, and a micrograph taken by an atomic force microscope is illustrated in Fig. 51. The profile in the height direction between A-B in Fig. 51 is illustrated in Fig. 53. In addition, regarding the SiC single crystal 1b produced in the first embodiment, a micrograph taken by the Nomarski differential interference contrast microscope is illustrated in Fig. 50, and a micrograph taken by the atomic force microscope is illustrated in Fig. 52. The profile in the height direction between A-B in Fig. 52 is illustrated in Fig. 54.

As illustrated in Figs. 49, 51, and 53, in the SiC single crystal 1a in which the flowing direction of the SiC solution and the step developing direction were substantially the same direction, steps having great step heights (that is, macrosteps) were formed. As described above, in the SiC single crystal 1a produced in the first embodiment, the average height of the steps was 103 nm. The surface roughness (Rq) of the crystal growth surface in the SiC single crystal 1a was 100 nm. On the other hand, the average height of the steps in the SiC single crystal 1b was 66 nm. In addition, the surface roughness (Rq) of the crystal growth surface in the SiC single crystal 1b was 70 nm. As described above, in the SiC single crystal 1a, the conversion of threading screw dislocations had occurred. Therefore, this result supports that in order to cause the conversion of threading screw dislocations, the surface roughness (Rq) of the crystal growth surface is preferably greater than 70 nm, and the surface roughness (Rq) of the crystal growth surface is more preferably equal to or greater than 100 nm.

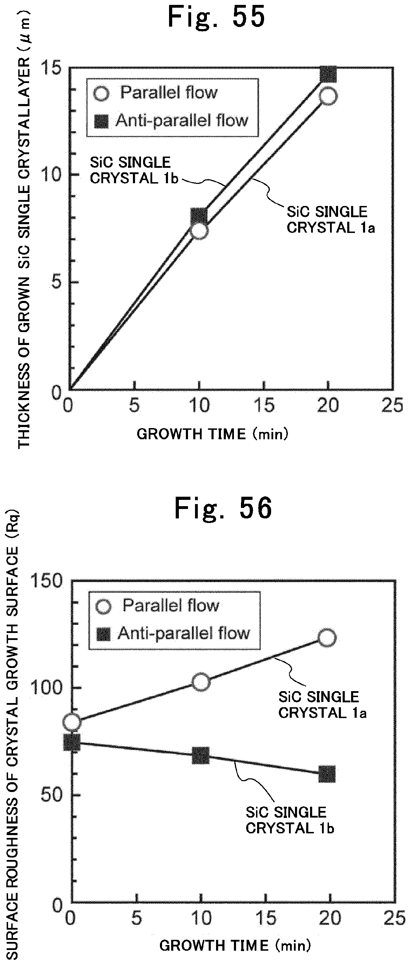

Regarding the SiC single crystals 1a and 1b produced in the first embodiment, the relationship between the thickness ($\mu$m) of the SiC single crystal layer grown on the SiC seed crystal and the growth time (min) is illustrated in Fig. 55. In addition, regarding the SiC single crystals 1a and 1b produced in the first embodiment, the relationship between the growth time (min) and the surface roughness (Rq) of the crystal growth surface is illustrated in Fig. 56. As illustrated in Fig. 55, regardless whether the flowing direction of the SiC solution and the step developing direction were the same direction or opposite directions to each other, the thickness of the grown SiC single crystal layer was increased in proportion to the growth time. On the other hand, as illustrated in Fig. 56, the surface roughness (Rq) of the crystal growth surface was increased in the case where the flowing direction of the SiC solution and the step developing direction were the same direction (the SiC single crystal 1a) and was decreased in the case where the flowing direction of the SiC solution and the step developing direction were opposite directions to each other. This result also supports that the step height and the surface roughness (Rq) of the crystal growth surface have a close relationship and the surface roughness (Rq) of the crystal growth surface is increased when the step height increases.

(Others)

The present invention is not limited only to the embodiments described above and illustrated in the figures and can be appropriately modified. For example, before the crystal growth process, a process (preparation process) of guiding the step developing direction to the flowing direction of the raw material solution by growing a seed crystal in which an off angle is not formed while allowing the raw material solution to flow may be provided. In addition, a single crystal obtained in the preparation process may be used in the crystal growth process as the seed crystal.

In addition, the flowing direction of the raw material solution in the crystal growth process may not be completely coincident with the step developing direction of the single crystal. For example, the step developing direction in a portion of the single crystal may be different from the step developing direction in the other portions, and a portion of the raw material solution may be allowed to flow in a different direction from that of the other portions.

[Relationship between Crystal Growth and Conversion Ratio of Threading Dislocations]

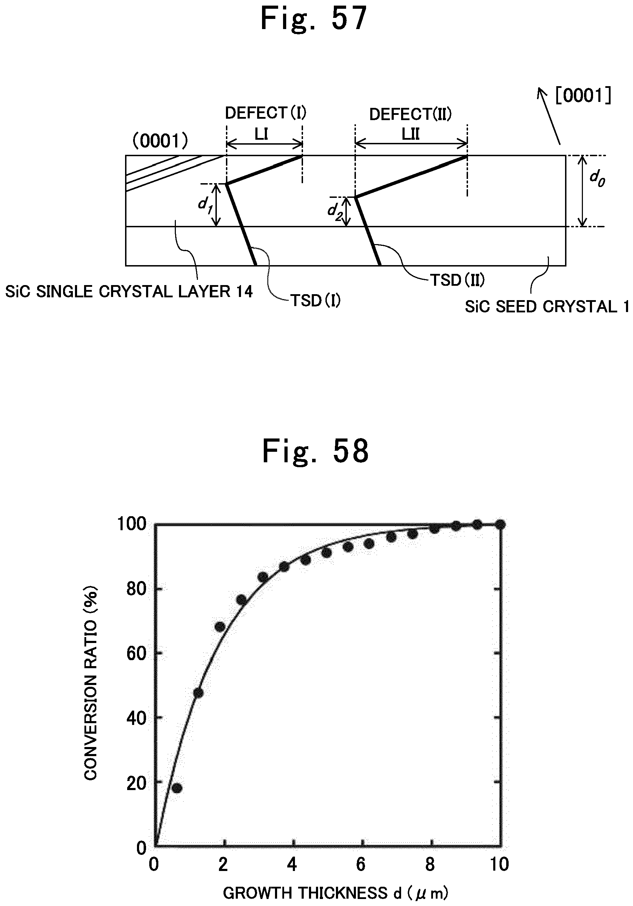

As described above, the step height is closely associated with both the conversion of threading screw dislocations TSD and the conversion of threading edge dislocations TED. In addition, the threading dislocations can be efficiently converted by the macrosteps. However, conversion of the threading dislocations by the macrosteps does not always occur. That is, there may be cases where threading dislocations may remain in the grown SiC single crystal. As illustrated in Fig. 57, the conversion of threading dislocations does not occur simultaneously but occurs at different timings. Therefore, the growth thickness of the SiC single crystal layer at the time point when the conversion of threading dislocations occurs also varies. In addition, "the growth thickness of the SiC single crystal layer at the time point when the conversion of threading dislocations occurs" can also be rephrased as "a necessary growth thickness of the SiC single crystal layer to cause the conversion of threading dislocations after the start of the crystal growth".

As illustrated in Fig. 57, it is assumed that the growth thickness of a SiC single crystal layer 14 at the time point when conversion of TSD (I) occurs is $d_1$, the growth thickness of a SiC single crystal layer 14 at the time point when conversion of TSD (II) occurs is $d_2$, and d1 > d2 is satisfied. In this case, a length LI of a defect (I) caused by the conversion of the TSD (I) is shorter than a length LII of a defect (II) caused by the conversion of the TSD (II). That is, when the conversion of the threading dislocations occurs at an initial growth stage of the SiC single crystal layer, the length of the defect caused by the conversion is further increased.

The length of the defect can be evaluated on the basis of an X-ray topograph. In addition, when it is assumed that the length of a defect in the X-ray topograph is L, the overall thickness of a SiC single crystal layer is $d_0$, a necessary growth thickness of the SiC single crystal layer 14 to cause the conversion of threading dislocations is d, and an off angle of the seed crystal is $\theta$, in this case, L, $d_0$, d, and $\theta$ satisfy a relationship of $L = (d_0-d)/\tan\theta$. Therefore, by examining the distribution of the lengths L of defects on the basis of the X-ray topograph, a change in the conversion ratio of defects with the growth thickness d of the SiC single crystal layer 14 is seen.

(Conversion Ratio of TSD)

An X-ray topograph of the SiC single crystal of Test 7 was taken, and the relationship between the conversion ratio (%) of TSD and a necessary growth thickness d of the SiC single crystal layer to cause the conversion of threading dislocations was examined. A graph illustrating the relationship between the conversion ratio (%) of TSD and the growth thickness d is illustrated in Fig. 58. As illustrated in Fig. 58, the conversion ratio (%) of TED exponentially increases as the growth thickness d increases. In addition, a plot representing the relationship between the conversion ratio (%) of TSD and the growth thickness d may be fitted as an exponential distribution ($f(t) = 1-e^{-(t/\eta)}$ : $\eta = 1.9 \mu m$). This means that the conversion of TSD by macrosteps occurs at a predetermined probability.

(Conversion Ratio of TED)

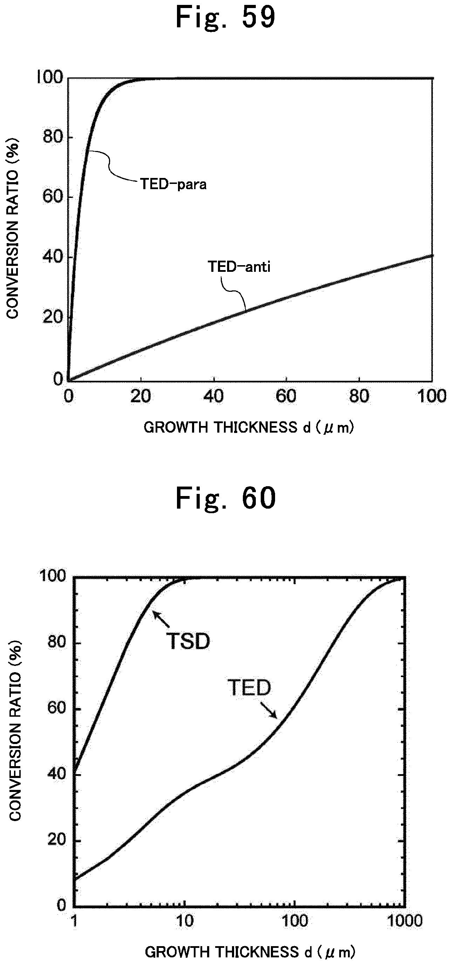

An X-ray topograph of the SiC single crystal of Test 7 was taken, and the relationship between the conversion ratio (%) of TED and the necessary growth thickness d was examined. In addition, the relationship between the two was separately examined regarding TED (TED-para: crossing angle of $0°\pm15°$ and crossing angle of $180°\pm15°$) in which the Burgers vector and the step developing direction are substantially parallel to each other, and TED (TED-anti: crossing angle of $60°\pm15°$, crossing angle of $120°\pm15°$, crossing angle of $240°\pm15°$, and crossing angle of $300°\pm15°$) in which the Burgers vector and the step developing direction are not parallel to each other. A graph illustrating the relationship between the conversion ratio (%) of TED and the growth thickness d is illustrated in Fig. 59. In addition, like the curve illustrated in Fig. 58, the curve illustrated in Fig. 59 is a curve in which a plot representing the relationship between the conversion ratio (%) of TED and the growth thickness d is fitted on the premise of an exponential function. Specifically, when the growth thickness d is about 10 $\mu m$, 90% or more of TED-para is converted. Contrary to this, the conversion ratio (%) of TED-anti is low. However, the conversion ratio (%) of TED-anti increases as the growth thickness d increases, and when crystal growth is continued until the growth thickness d reaches 100 $\mu m$, the conversion ratio (%) of TED-anti increases up to about 40%.

A graph of the relationship between the conversion ratio (%) of TSD, the conversion ratio (%) of TED, and the growth thickness d based on the relationship between the conversion ratio (%) of TSD and the growth thickness d and the relationship between the conversion ratio (%) of TED and the growth thickness d is illustrated in Fig. 60. In addition, the conversion ratio of TED was calculated by using the result of Test 12 assuming that the Burgers vectors of the threading edge dislocations are uniformly distributed in all the six directions. Specifically, the conversion ratio of TED in the case where the Burgers vector and the step developing direction are the same direction or in the case where the Burgers vector and the step developing direction are opposite directions to each other was calculated on the basis of the conversion ratio of TED-para (curve). In addition, the conversion ratio of TED in a case where the Burgers vector is the other directions was calculated on the basis of the conversion ratio of TED-anti (curve). In addition, the conversion ratio of TED was calculated on the basis of the values regardless of the direction of the Burgers vector. As illustrated in Fig. 60, 99% or more of TSD was converted when the growth thickness d had reached about 10 $\mu m$. In addition, it can be seen that almost all TED is converted when the growth thickness d reaches about 1 mm.

[Reference Signs List]

1: SiC seed crystal
2: crystal producing apparatus
3: crystal holding element
TSD: threading screw dislocation
SF: stacking fault
h: step height
P1, P2: terrace surface
$S_m$: macrostep
20: crucible
23: heating element
24a: dipping shaft portion
25: solution flowing element
28: holding portion
29: raw material solution
30x: x-direction guide portion
30y: y-direction guide portion

30z: z-direction guide portion

**Claims**

1. A SiC single crystal producing method using a crystal producing apparatus (2), the apparatus comprising:

   a liquid tub (20) which accommodates a raw material solution (29) containing silicon (Si) and carbon (C), a radial cross-section of an inner surface of the liquid tub (20) being circular;
   a crystal holding element (3) including a dipping shaft portion (24a) which holds a SiC seed crystal (1) in the liquid tub (20) on the outside in a radial direction from a z-axis that extends in a depth direction of the liquid tub (20) and is positioned at a center of the radial cross-section; and
   a solution flowing element (3; 25) which allows the raw material solution (29) in the liquid tub (20) to flow in an arc direction along the inner surface of the liquid tub (20),
   the method comprising:

   a crystal growth process of growing a SiC single crystal (10) by developing steps (S) made of SiC on a crystal growth surface (100) of the SiC seed crystal (1) by a liquid phase growth method in the raw material solution (29),
   **characterized in that**
   the crystal holding element (3) is movable in at least a partial region on an xy plane perpendicular to the z-axis, the crystal holding element (3) is configured to allow the dipping shaft portion (24a) to revolve around the z-axis and rotate on its own axis so that an orientation of the crystal growth surface (100) of the SiC seed crystal (1) with respect to a flowing direction of the raw material solution (29) can be set to two directions that are 180° different from each other, and
   the crystal growth process includes a smoothening process of removing at least a portion of step bunchings on the crystal growth surface (100) by causing the raw material solution (29) to flow along a direction opposite to a developing direction of the steps (S) by adding an external force to the raw material solution (29) using the solution flowing element (3; 25).

2. A SiC single crystal producing method using a crystal producing apparatus (2), the apparatus comprising:

   a liquid tub (20) which accommodates a raw material solution (29) containing silicon (Si) and carbon (C), a radial cross-section of an inner surface of the liquid tub (20) being circular;
   a crystal holding element (3) including a dipping shaft portion (24a) which holds a SiC seed crystal (1) in the liquid tub (20) on the outside in a radial direction from a z-axis that extends in a depth direction of the liquid tub (20) and is positioned at a center of the radial cross-section; and
   a solution flowing element (3; 25) which allows the raw material solution (29) in the liquid tub (20) to flow in an arc direction along the inner surface of the liquid tub (20),
   the method comprising:

   a crystal growth process of growing a SiC single crystal (10) by developing steps (S) made of SiC on a crystal growth surface (100) of the SiC seed crystal (1) by a liquid phase growth method in the raw material solution (29),
   **characterized in that**
   the crystal holding element (3) is movable in at least a partial region on an xy plane perpendicular to the z-axis, the crystal holding element (3) is configured to allow the dipping shaft portion (24a) to revolve around the z-axis and rotate on its own axis so that an orientation of the crystal growth surface (100) of the SiC seed crystal (1) with respect to a flowing direction of the raw material solution (29) can be set to two directions that are 180° different from each other, and
   the crystal growth process includes a bunching process of generating step bunchings on the crystal growth surface (100) by causing the raw material solution (29) to flow along a developing direction of the steps (S) by adding an external force to the raw material solution (29) using the solution flowing element (3; 25).

3. The SiC single crystal producing method according to claim 2,
   wherein, in the bunching process, macrosteps (Sm) which are made of the SiC single crystal (10) and have a height (h) of greater than 70 nm are formed by the step bunchings.

**4.** The SiC single crystal producing method according to claim 3,
wherein, in the bunching process, macrosteps (Sm) which have a height (h) of greater than or equal to 80 nm are formed by the step bunchings.

**5.** The SiC single crystal producing method according to claim 2,
wherein, in the bunching process, macrosteps (Sm) which have a height (h) of greater than or equal to 100 nm are formed by the step bunchings.

**6.** The SiC single crystal producing method according to claim 2,
wherein 4H-SiC or 6H-SiC is used as the SiC seed crystal (1),
the crystal growth surface (100) is a (0001) plane, and
the developing direction of the steps (S) in the crystal growth process is at least one direction selected from (1) to (3) as follows:

(1) a direction in which a crossing angle with respect to a [-1-120] direction is -30° or less and less than +30° or a direction in which a crossing angle with respect to a [11-20] direction is -30° or less and less than +30°;
(2) a direction in which a crossing angle with respect to a [-2110] direction is -30° or less and less than +30° or a direction in which a crossing angle with respect to a [21-10] direction is -30° or less and less than +30°; and
(3) a direction in which a crossing angle with respect to a [-1210] direction is -30° or less and less than +30° or a direction in which a crossing angle with respect to a [1-210] direction is -30° or less and less than +30°.

**7.** The SiC single crystal producing method according to claim 6,
wherein the developing direction of the steps (S) in the crystal growth process is at least two directions selected from (1) to (3).

**8.** The SiC single crystal producing method according to claim 6,
wherein the directions of (1) to (3) are as follows:

(1) a direction in which the crossing angle with respect to the [-1-120] direction is $\pm15°$ or less or a direction in which the crossing angle with respect to the [11-20] direction is $\pm15°$ or less;
(2) a direction in which the crossing angle with respect to the [-2110] direction is $\pm15°$ or less or a direction in which the crossing angle with respect to the [21-10] direction is $\pm15°$ or less; and
(3) a direction in which the crossing angle with respect to the [-1210] direction is $\pm15°$ or less or a direction in which the crossing angle with respect to the [1-210] direction is $\pm15°$ or less.

**9.** The SiC single crystal producing method according to claim 3,
wherein, as the SiC seed crystal (1), a SiC seed crystal provided with a first region (A1) in which an off angle is formed and a second region (A2) in which an off angle is not formed at the crystal growth surface (100) is used.

**10.** The SiC single crystal producing method according to any one of claims 1 to 9,
wherein the raw material solution (29) is allowed to flow by movement of the crystal holding element (3), and
the solution flowing element includes the crystal holding element (3).

**11.** The SiC single crystal producing method according to any one of claims 1 to 10,
wherein the crystal holding element (3) includes a guide element (30) which guides a movement direction of the dipping shaft portion (24a), and
the guide element (30) includes a z-direction guide portion (30z) which guides the dipping shaft portion (24a) to the z-axis direction, an x-direction guide portion (30x) which guides the dipping shaft portion (24a) to an x-axis direction which is one direction on the xy plane, and a y-direction guide portion (30y) which guides the dipping shaft portion (24a) to a y-axis direction which is one direction on the xy plane and intersects the x-axis direction.


**Patentansprüche**

**1.** SiC-Einkristall-Herstellungsverfahren, das eine Kristallherstellungsvorrichtung (2) verwendet, die Folgendes umfasst:

eine Flüssigkeitswanne (20), die eine Silizium (Si) und Kohlenstoff (C) enthaltende Rohmateriallösung (29) aufnimmt, wobei ein radialer Querschnitt einer Innenfläche der Flüssigkeitswanne (20) kreisförmig ist; ein Kristallhalteelement (3), das einen Tauchwellenabschnitt (24a) aufweist, der einen SiC-Impfkristall (1) in der Flüssigkeitswanne (20) in einer radialen Richtung von einer z-Achse, die sich in einer Tiefenrichtung der Flüssigkeitswanne (2) erstreckt und in einer Mitte des radialen Querschnitts positioniert ist, auf der Außenseite hält; und

ein Lösungsfließelement (3; 25), das die Rohmateriallösung (29) in der Flüssigkeitswanne (20) in einer Bogenrichtung entlang der Innenfläche der Flüssigkeitswanne (20) fließen lässt, wobei das Verfahren Folgendes umfasst:

einen Kristallzüchtungsprozess, in dem ein SiC-Einkristall (10) gezüchtet wird, indem in der Rohmateriallösung (29) auf einer Kristallzüchtungsfläche (100) des SiC-Impfkristalls (1) durch ein Flüssigphasenzüchtungsverfahren aus SiC bestehende Stufen (S) entwickelt werden,

**dadurch gekennzeichnet, dass**

das Kristallhalteelement (3) in zumindest einem Teilbereich auf einer zur z-Achse senkrechten xy-Ebene bewegbar ist,

das Kristallhalteelement (3) so konfiguriert ist, dass es dem Tauchwellenabschnitt (24a) erlaubt, sich um die z-Achse zu drehen und sich um seine eigene Achse zu drehen, sodass eine Orientierung der Kristallzüchtungsfläche (100) des SiC-Impfkristalls (1) bezüglich einer Fließrichtung der Rohmateriallösung (29) auf zwei Richtungen eingestellt werden kann, die voneinander um 180° verschieden sind, und

der Kristallzüchtungsprozess einen Glättungsprozess beinhaltet, in dem zumindest ein Abschnitt von Stufenanhäufungen auf der Kristallzüchtungsfläche (100) entfernt wird, indem die Rohmateriallösung (29) unter Verwendung des Lösungsfließelements (3; 25) durch Hinzufügen einer äußeren Kraft zur Rohmateriallösung (29) dazu gebracht wird, entlang einer Richtung zu fließen, die entgegengesetzt zu einer Entwicklungsrichtung der Stufen (S) ist.

2. SiC-Einkristall-Herstellungsverfahren, das eine Kristallherstellungsvorrichtung (2) verwendet, die Folgendes umfasst:

eine Flüssigkeitswanne (20), die eine Silizium (Si) und Kohlenstoff (C) enthaltende Rohmateriallösung (29) aufnimmt, wobei ein radialer Querschnitt einer Innenfläche der Flüssigkeitswanne (20) kreisförmig ist; ein Kristallhalteelement (3), das einen Tauchwellenabschnitt (24a) aufweist, der einen SiC-Impfkristall (1) in der Flüssigkeitswanne (20) in einer radialen Richtung von einer z-Achse, die sich in einer Tiefenrichtung der Flüssigkeitswanne (2) erstreckt und in einer Mitte des radialen Querschnitts positioniert ist, auf der Außenseite hält; und

ein Lösungsfließelement (3; 25), das die Rohmateriallösung (29) in der Flüssigkeitswanne (20) in einer Bogenrichtung entlang der Innenfläche der Flüssigkeitswanne (20) fließen lässt, wobei das Verfahren Folgendes umfasst:

einen Kristallzüchtungsprozess, in dem ein SiC-Einkristall (10) gezüchtet wird, indem in der Rohmateriallösung (29) auf einer Kristallzüchtungsfläche (100) des SiC-Impfkristalls (1) durch ein Flüssigphasenzüchtungsverfahren aus SiC bestehende Stufen (S) entwickelt werden,

**dadurch gekennzeichnet, dass**

das Kristallhalteelement (3) in zumindest einem Teilbereich auf einer zur z-Achse senkrechten xy-Ebene bewegbar ist,

das Kristallhalteelement (3) so konfiguriert ist, dass es dem Tauchwellenabschnitt (24a) erlaubt, sich um die z-Achse zu drehen und sich um seine eigene Achse zu drehen, sodass eine Orientierung der Kristallzüchtungsfläche (100) des SiC-Impfkristalls (1) bezüglich einer Fließrichtung der Rohmateriallösung (29) auf zwei Richtungen eingestellt werden kann, die voneinander um 180° verschieden sind, und

der Kristallzüchtungsprozess einen Anhäufungsprozess beinhaltet, in dem auf der Kristallzüchtungsfläche (100) Stufenanhäufungen erzeugt werden, indem die Rohmateriallösung (29) unter Verwendung des Lösungsfließelements (3; 25) durch Hinzufügen einer äußeren Kraft zur Rohmateriallösung (29) dazu gebracht wird, entlang einer Entwicklungsrichtung der Stufen (S) zu fließen.

3. SiC-Einkristall-Herstellungsverfahren nach Anspruch 2,
wobei in dem Anhäufungsprozess durch die Stufenanhäufungen Makrostufen (Sm) ausgebildet werden, die aus dem SiC-Einkristall (10) bestehen und eine Höhe (h) von mehr als 70 nm haben.

4. SiC-Einkristall-Herstellungsverfahren nach Anspruch 3,

wobei in dem Anhäufungsprozess durch die Stufenanhäufungen Makrostufen (Sm) ausgebildet werden, die eine Höhe (h) von größer oder gleich 80 nm haben.

5. SiC-Einkristall-Herstellungsverfahren nach Anspruch 2,
wobei in dem Anhäufungsprozess durch die Stufenanhäufungen Makrostufen (Sm) ausgebildet werden, die eine Höhe (h) von größer oder gleich 100 nm haben.

6. SiC-Einkristall-Herstellungsverfahren nach Anspruch 2,
wobei 4H-SiC oder 6H-SiC als SiC-Impfkristall (1) verwendet wird,
die Kristallzüchtungsfläche (100) eine (0001)-Ebene ist und
die Entwicklungsrichtung der Stufen (S) in dem Kristallzüchtungsprozess mindestens eine Richtung ist, die wie folgt aus (1) bis (3) ausgewählt ist:

(1) eine Richtung, in der ein Kreuzungswinkel bezüglich einer [-1-120]-Richtung -30° oder weniger und weniger als +30° beträgt, oder eine Richtung, in der ein Kreuzungswinkel bezüglich einer [11-20]-Richtung -30° oder weniger und weniger als +30° beträgt;
(2) eine Richtung, in der ein Kreuzungswinkel bezüglich einer [-2110]-Richtung -30° oder weniger und weniger als +30° beträgt, oder eine Richtung, in der ein Kreuzungswinkel bezüglich einer [21-10]-Richtung -30° oder weniger und weniger als +30° beträgt; und
(3) eine Richtung, in der ein Kreuzungswinkel bezüglich einer [-1210]-Richtung -30° oder weniger und weniger als +30° beträgt, oder eine Richtung, in der ein Kreuzungswinkel bezüglich einer [1-210]-Richtung -30° oder weniger und weniger als +30° beträgt.

7. SiC-Einkristall-Herstellungsverfahren nach Anspruch 6,
wobei die Entwicklungsrichtung der Schritte (S) im Kristallzüchtungsprozess mindestens zwei Richtungen ist, die aus (1) bis (3) ausgewählt sind.

8. SiC-Einkristall-Herstellungsverfahren nach Anspruch 6,
wobei die Richtungen (1) bis (3) wie folgt sind:

(1) eine Richtung, in der der Kreuzungswinkel bezüglich der [-1-120]-Richtung $\pm 15°$ oder weniger beträgt, oder eine Richtung, in der der Kreuzungswinkel bezüglich der [11-20]-Richtung $\pm 15°$ oder weniger beträgt;
(2) eine Richtung, in der der Kreuzungswinkel bezüglich der [-2110]-Richtung $\pm 15°$ oder weniger beträgt, oder eine Richtung, in der der Kreuzungswinkel bezüglich der [21-10]-Richtung $\pm 15°$ oder weniger beträgt; und
(3) eine Richtung, in der der Kreuzungswinkel bezüglich der [-1210]-Richtung $\pm 15°$ oder weniger beträgt, oder eine Richtung, in der der Kreuzungswinkel bezüglich der [1-210]-Richtung $\pm 15°$ oder weniger beträgt.

9. SiC-Einkristall-Herstellungsverfahren nach Anspruch 3,
wobei als SiC-Impfkristall (1) ein SiC-Impfkristall verwendet wird, der an der Kristallzüchtungsfläche (100) mit einem ersten Bereich (A1), in dem ein Versatzwinkel ausgebildet ist, und einem zweiten Bereich (A2), in dem kein Versatzwinkel ausgebildet ist, versehen ist.

10. SiC-Einkristall-Herstellungsverfahren nach einem der Ansprüche 1 bis 9,
wobei die Rohmateriallösung (29) durch Bewegung des Kristallhalteelements (3) fließen gelassen wird und
das Lösungsfließelement das Kristallhalteelement (3) umfasst.

11. SiC-Einkristall-Herstellungsverfahren nach einem der Ansprüche 1 bis 10,
wobei das Kristallhalteelement (3) ein Führungselement (30) umfasst, das eine Bewegungsrichtung des Tauchwellenabschnitts (24a) führt, und
das Führungselement (30) einen z-Richtungsführungsabschnitt (30z), der den Tauchwellenabschnitt (24a) in der z-Achsenrichtung führt, einen x-Richtungsführungsabschnitt (30x), der den Tauchwellenabschnitt (24a) in einer x-Achsenrichtung führt, die eine Richtung auf der xy-Ebene ist, und einen y-Richtungsführungsabschnitt (30y) umfasst, der den Tauchwellenabschnitt (24a) in einer y-Achsenrichtung führt, die eine Richtung auf der xy-Ebene ist und die x-Achsenrichtung schneidet.

**Revendications**

1. Procédé de production d'un monocristal de SiC utilisant un dispositif de production de cristaux (2), le dispositif comprenant :

   un bac de liquide (20) qui contient une solution de matière première (29) comprenant du silicium (Si) et du carbone (C), la section transversale radiale d'une surface intérieure du bac de liquide (20) étant circulaire ;
   un élément de retenue de cristaux (3) comprenant une partie formant arbre d'immersion (24a) qui retient un germe cristallin de SiC (1) dans le bac de liquide (20) sur l'extérieur dans une direction radiale par rapport à un axe z qui s'étend dans la direction de la profondeur du bac de liquide (20) et qui est positionnée au centre de la section transversale radiale ; et
   un élément de circulation de solution (3 ; 25) qui permet à la solution de matière première (29) dans le bac de liquide (20) de circuler dans une direction formant un arc le long de la surface intérieure du bac de liquide (20), le procédé comprenant :

   un traitement de croissance cristalline consistant à faire croître un monocristal de SiC (10) en développant des gradins (S) faits de SiC sur une surface de croissance cristalline (100) du germe cristallin de SiC (1) par un procédé de croissance en phase liquide dans la solution de matière première (29),
   **caractérisé en ce que**
   l'élément de retenue de cristaux (3) est mobile dans au moins une région partielle sur un plan xy perpendiculaire à l'axe z,
   l'élément de retenue de cristaux (3) est configuré pour permettre à la partie formant arbre d'immersion (24a) de pivoter autour de l'axe z et de tourner sur son propre axe de façon que l'orientation de la surface de croissance cristalline (100) du germe cristallin de SiC (1) par rapport à la direction de circulation de la solution de matière première (29) puisse être établie à deux directions qui sont différentes l'une de l'autre de 180°, et
   le traitement de croissance cristalline comprend un traitement de lissage consistant à retirer au moins une partie des entassements de gradins sur la surface de croissance cristalline (100) en forçant la solution de matière première (29) à circuler le long d'une direction opposée à la direction de développement des gradins (S) par addition d'une force externe à la solution de matière première (29) utilisant l'élément de circulation de solution (3 ; 25).

2. Procédé de production d'un monocristal de SiC utilisant un dispositif de production de cristaux (2), le dispositif comprenant :

   un bac de liquide (20) qui contient une solution de matière première (29) comprenant du silicium (Si) et du carbone (C), la section transversale radiale d'une surface intérieure du bac de liquide (20) étant circulaire ;
   un élément de retenue de cristaux (3) comprenant une partie formant arbre d'immersion (24a) qui retient un germe cristallin de SiC (1) dans le bac de liquide (20) sur l'extérieur dans une direction radiale par rapport à un axe z qui s'étend dans la direction de la profondeur du bac de liquide (20) et qui est positionnée au centre de la section transversale radiale ; et
   un élément de circulation de solution (3 ; 25) qui permet à la solution de matière première (29) dans le bac de liquide (20) de circuler dans une direction formant un arc le long de la surface intérieure du bac de liquide (20), le procédé comprenant :

   un traitement de croissance cristalline consistant à faire croître un monocristal de SiC (10) en développant des gradins (S) faits de SiC sur une surface de croissance cristalline (100) du germe cristallin de SiC (1) par un procédé de croissance en phase liquide dans la solution de matière première (29),
   **caractérisé en ce que**
   l'élément de retenue de cristaux (3) est mobile dans au moins une région partielle sur un plan xy perpendiculaire à l'axe z,
   l'élément de retenue de cristaux (3) est configuré pour permettre à la partie formant arbre d'immersion (24a) de pivoter autour de l'axe z et de tourner sur son propre axe de façon que l'orientation de la surface de croissance cristalline (100) du germe cristallin de SiC (1) par rapport à la direction de circulation de la solution de matière première (29) puisse être établie à deux directions qui sont différentes l'une de l'autre de 180°, et
   le traitement de croissance cristalline comprend un traitement d'entassement consistant à générer des entassements de gradins sur la surface de croissance cristalline (100) en forçant la solution de matière première (29) à circuler le long de la direction de développement des gradins (S) par addition d'une force externe à la solution de matière première (29) utilisant l'élément de circulation de solution (3 ; 25).

3. Procédé de production d'un monocristal de SiC selon la revendication 2, dans lequel, dans le traitement d'entassement, des macro-gradins (Sm) qui sont faits du monocristal de SiC (10) et qui ont une hauteur (h) supérieure à 70 nm sont formés par les entassements de gradins.

4. Procédé de production d'un monocristal de SiC selon la revendication 3, dans lequel, dans le traitement d'entassement, des macro-gradins (Sm) qui ont une hauteur (h) supérieure ou égale à 80 nm sont formés par les entassements de gradins.

5. Procédé de production d'un monocristal de SiC selon la revendication 2, dans lequel, dans le traitement d'entassement, des macro-gradins (Sm) qui ont une hauteur (h) supérieure ou égale à 100 nm sont formés par les entassements de gradins.

6. Procédé de production d'un monocristal de SiC selon la revendication 2, dans lequel du 4H-SiC ou du 6H-SiC est utilisé en tant que germe cristallin de SiC (1), la surface de croissance cristalline (100) est un plan (0001), et la direction de développement des gradins (S) dans le traitement de croissance cristalline est au moins une direction choisie parmi (1) à (3) comme suit :

   (1) une direction dans laquelle l'angle de croisement par rapport à la direction [-1-120] est de -30 ° ou moins et inférieur à +30 ° ou une direction dans laquelle l'angle de croisement par rapport à la direction [11-20] est de -30 ° ou moins et inférieur à +30° ;
   (2) une direction dans laquelle l'angle de croisement par rapport à la direction [-2110] est de -30 ° ou moins et inférieur à +30 ° ou une direction dans laquelle l'angle de croisement par rapport à la direction [21-10] est de -30 ° ou moins et inférieur à +30° ; et
   (3) une direction dans laquelle l'angle de croisement par rapport à la direction [-1210] est de -30 ° ou moins et inférieur à +30 ° ou une direction dans laquelle l'angle de croisement par rapport à la direction [1-210] est de -30 ° ou moins et inférieur à +30 °.

7. Procédé de production d'un monocristal de SiC selon la revendication 6, dans lequel la direction de développement des grains (S) dans le traitement de croissance cristalline est au moins deux directions choisies parmi (1) à (3).

8. Procédé de production d'un monocristal de SiC selon la revendication 6, dans lequel les directions de (1) à (3) sont comme suit :

   (1) une direction dans laquelle l'angle de croisement par rapport à la direction [-1-120] est de $\pm15$ ° ou moins ou une direction dans laquelle l'angle de croisement par rapport à la direction [11-20] est de $\pm15$ ° ou moins ;
   (2) une direction dans laquelle l'angle de croisement par rapport à la direction [-2110] est de $\pm15$ ° ou moins ou une direction dans laquelle l'angle de croisement par rapport à la direction [21-10] est de $\pm15$ ° ou moins ; et
   (3) une direction dans laquelle l'angle de croisement par rapport à la direction [-1210] est de $\pm15$ ° ou moins ou une direction dans laquelle l'angle de croisement par rapport à la direction [1-210] est de $\pm15$ ° ou moins.

9. Procédé de production d'un monocristal de SiC selon la revendication 3, dans lequel, en tant que germe cristallin de SiC (1), est utilisé un germe cristallin de SiC doté d'une première région (A1) dans laquelle un angle de décalage est formé et une deuxième région (A2) dans laquelle un angle de décalage n'est pas formé au niveau de la surface de croissance cristalline (100) .

10. Procédé de production d'un monocristal de SiC selon l'une quelconque des revendications 1 à 9, dans lequel la solution de matière première (29) est laissée à circuler par le mouvement de l'élément de retenue de cristaux (3), et l'élément de circulation de solution comprend l'élément de retenue de cristaux (3).

11. Procédé de production d'un monocristal de SiC selon l'une quelconque des revendications 1 à 10, dans lequel l'élément de retenue de cristaux (3) comprend un élément formant guide (30) qui guide la direction de mouvement de la partie formant arbre d'immersion (24a), et

l'élément formant guide (30) comprend une partie formant guide dans la direction z (30z) qui guide la partie formant arbre d'immersion (24a) dans la direction de l'axe z, une partie formant guide dans la direction x (30x) qui guide la partie formant arbre d'immersion (24a) dans la direction de l'axe x qui est une direction sur le plan xy, et une partie formant guide dans la direction y (30y) qui guide la partie formant arbre d'immersion (24a) dans la direction de l'axe y qui est une direction sur le plan xy et qui coupe la direction de l'axe x.

# Fig. 1

# Fig. 2

# Fig. 3

# Fig. 4

# Fig. 5

# Fig. 6

# Fig. 7

# Fig. 8

● SiC SINGLE CRYSTAL 1b (OPPOSITE DIRECTIONS)
■ SiC SINGLE CRYSTAL 1a (SAME DIRECTION)

# Fig. 9

# Fig. 10

SiC SEED CRYSTAL

SiC SINGLE CRYSTAL
( AFTER CRYSTAL GROWTH )

# Fig. 11

# Fig. 12

# Fig. 13

# Fig. 14

# Fig. 15

TEST 1
(OFF ANGLE 1.25°)

# Fig. 16

TEST 2
(OFF ANGLE 2.00°)

# Fig. 17

TEST 3
(OFF ANGLE 4.00°)

# Fig. 18

# Fig. 19

# Fig. 20

# Fig. 21

(0001)

TSD

TSD

TSD

TSD

SiC SEED CRYSTAL 1

# Fig. 22

CRYSTAL GROWTH DIRECTION

STEP DEVELOPING DIRECTION

(0001)

Sm

(0001)

TSD

TSD

TSD

TSD

# Fig. 23

CRYSTAL GROWTH DIRECTION

STEP DEVELOPING DIRECTION

(0001)

Sm

(0001)

SF

TSD

TSD

TSD

TSD

TSD

# Fig. 24

CRYSTAL GROWTH DIRECTION

STEP DEVELOPING DIRECTION

SiC SINGLE CRYSTAL 10

(0001)

13

SF

12

SF

SF

SF

SF

SF

11

TSD

# Fig. 25

# Fig. 26

SiC SEED CRYSTAL 1

SECOND SEED CRYSTAL 15

# Fig. 27

CRYSTAL GROWTH DIRECTION

STEP DEVELOPING DIRECTION

V1

S₁

V2

S₂

SiC SEED CRYSTAL 1

W₁

W₂

$V_1 > V_2$

# Fig. 28

200μm

# Fig. 29

# Fig. 30

# Fig. 31

CRYSTAL GROWTH DIRECTION

STEP DEVELOPING DIRECTION

# Fig. 32

(0001)

[1-100]  [11-20]

A2

1

A1

# Fig. 33

CRYSTAL GROWTH DIRECTION

STEP DEVELOPING
DIRECTION

STEP DEVELOPING
DIRECTION

SiC SINGLE CRYSTAL 10

1

A2

A1

# Fig. 34

100 µm

# Fig. 35

100 µm

# Fig. 36

# Fig. 37

# Fig. 38

(0001) →[11−20]    200 μm

[1−100]

STEP DEVELOPING
DIRECTION

(0001) →[11−20]    200 μm

[1−100]

STEP DEVELOPING
DIRECTION

# Fig. 39

[−2110] (2)

[−12−10]

(3)

(1)

[−1−120]

0 20 40 60 80 100(%)

[11−20]

(1)

(3)

(2)

[1−210]

[2−1−10]

STEP DEVELOPING
DIRECTION

# Fig. 40

Si SURFACE / SiC SOLUTION

ROOT MEAN SQUARE ROUGHNESS (Rq) : 130nm

# Fig. 41

C SURFACE / SiC SOLUTION

ROOT MEAN SQUARE ROUGHNESS (Rq) : 70nm

EP 2 889 397 B1

# Fig. 42

C SURFACE / Si-Al-C SOLUTION

ROOT MEAN SQUARE ROUGHNESS (Rq) : 45nm

# Fig. 43

Si SURFACE / SiC SOLUTION

STEP HEIGHT ABOUT 200nm

# Fig. 44

C SURFACE / SiC SOLUTION

STEP HEIGHT ABOUT 10nm

# Fig. 45

C SURFACE / Si-Al-C SOLUTION

STEP HEIGHT ABOUT 1nm

## Fig. 46

## Fig. 47

## Fig. 48

# Fig. 49

# Fig. 50

# Fig. 51

# Fig. 52

# Fig. 53

# Fig. 54

## Fig. 55

## Fig. 56

# Fig. 57

# Fig. 58

## Fig. 59

## Fig. 60

**EP 2 889 397 B1**

**REFERENCES CITED IN THE DESCRIPTION**

**Patent documents cited in the description**

- JP 2011126738 A
- JP 2008100854 A
- EP 1806437 A1
- JP 2008308347 A
- US 20120073495 A1
- JP H11171689 A